# EUROPEAN PATENT APPLICATION

(11) **EP 4 588 328 A1**
(43) Date of publication of application: **23.07.2025**
(21) Application number: 23864702.8
(22) Date of filing: 13.09.2023
(51) Int. Cl.: A01D 34/69, A01D 34/82, A01D 34/74, A01D 34/685, H05K 7/20, H05K 5/02

(54) **GARDEN TOOL**

(30) Priority: 17.09.2022 CN 202211132324; 11.11.2022 CN 202211413613; 11.11.2022 CN 202223005427 U; 11.11.2022 CN 202223006313 U; 11.11.2022 CN 202223006304 U; 25.11.2022 CN 202223138099 U; 25.11.2022 CN 202211488392; 21.12.2022 CN 202211647971
(71) Applicant: Greenworks (Jiangsu) Co., Ltd., Changzhou, Jiangsu 213023 (CN)
(72) Inventor: TIAN, Bing, hangzhou, Jiangsu 213023 (CN); ZHANG, Yong, hangzhou, Jiangsu 213023 (CN); HE, Yaoting, hangzhou, Jiangsu 213023 (CN); TAO, Wen, hangzhou, Jiangsu 213023 (CN); FENG, Shouchuan, hangzhou, Jiangsu 213023 (CN); WANG, Yu, hangzhou, Jiangsu 213023 (CN)
(74) Representative: Bergenstråhle & Partners AB
(86) International application number: PCT/CN2023/118408
(87) International publication number: WO 2024/055970

(57) **Abstract**

A garden tool includes a main body, a handle assembly, a walking wheel assembly, a power box, and a control box. The handle assembly is connected with the main body and extends backward from one side of the main body for the user to push. The walking wheel assembly is arranged under the main body and is used to carry the main body and drive the main body to walk on a ground. The power box is arranged on the main body and is used to supply power for the garden tool. The control box is arranged on the main body, located beside the power box, and is used to control the garden tool to work. The control box and the power box are both arranged on an upper surface of the main body, and the control box is arranged close to the handle assembly.

## Description

### CROSS REFERENCE TO RELATED APPLICATION

The present application is a continuation Application of PCT application No. PCT/CN2023/118408 filed on September 13, 2023, which claims the benefit of CN202211132324.1 filed on September 17, 2022, CN202211413613.9 filed on November 11, 2022, CN202223006313.7 filed on November 11, 2022, CN202211488392.1 filed on November 25, 2022, CN202211647971.6 filed on December 21, 2022, CN202223005427.X filed on November 11, 2022, CN202223006304.8 filed on November 11, 2022, and CN202223138099.0 filed on November 25, 2022. All the above are hereby incorporated by reference for all purposes.

### TECHNICAL FIELD

The disclosure relates to a garden tool, which belongs to a technical field of garden devices.

### BACKGROUND

A lawn mower is a mechanical tool used to mow lawns, vegetation and other green areas. It includes a blade, a casing, a power head, a walking mechanism, an armrest, a collection device, a control device, etc. It has a wide range of uses, and is mainly used in garden decoration pruning, lawn greening pruning, urban streets, green spots, garden pruning, field weeding, especially in the park's lawn or grassland, football fields and other grass fields, private villa gardens, and agricultural, forestry and animal husbandry land vegetation maintenance, etc. When using it, the mowing height after mowing should be determined according to the requirements of the lawn.

Conventional lawn mowers usually integrate a control box and a power box for controlling the normal operation of the lawn mower to form a power head, which not only enables the layout of the lawn mower not to be compact, but also when a component of the control box or the power box fails, the power head needs to be replaced as a whole, which results in high maintenance costs.

In view of this, it is necessary to improve the conventional lawn mowers to solve the problems mentioned above.

### SUMMARY

The disclosure provides a garden tool, the garden tool arranges a power box and a control box separately, which not only enables a structural arrangement of each part to be more compact, but also allows them to be replaced separately when an abnormality occurs in the power box or the control box, thereby reducing maintenance costs.

One or more embodiments of the disclosure provide the garden tool. The garden tool includes a main body, a handle assembly, a walking wheel assembly, a power box, and a control box.

The handle assembly is connected with the main body and extends backward from one side of the main body for a user to push.

The walking wheel assembly is arranged under the main body and configured to carry the main body and drive the main body to walk on a ground.

The power box is arranged on the main body and configured to supply power to the garden tool.

The control box is arranged on the main body, located beside the power box, and configured to control the garden tool to work.

Wherein, the control box and the power box are both arranged on an upper surface of the main body, and the control box is arranged close to the handle assembly.

Further, the control box includes an upper cover, a control board and a filter component.

The upper cover and the box form a first accommodating space.

The control board is accommodated in the accommodating space, and a fan is arranged on a top of the control board and communicated with an air outlet passage.

The filter component is assembled and matched with the box and the upper cover, and a filter hole communicated with an outside is opened at a bottom of the filter component.

Wherein, the box is provided with an opening hole communicating the first accommodating space with the filter hole, in a height direction of the control box, the opening hole is located above the filter hole, the air outlet passage extends in a horizontal direction, a first end of the air outlet passage is communicated with an air outlet of the fan, a second end of the air outlet passage extends to be communicated with the outside, and the fan is configured so that external airflow enters from the filter hole, first goes up to the opening hole, then goes down to the first accommodating space, passes through the control board, gathers at the fan and flows out through the air outlet passage.

Further, the control board includes a first control board and a second control board, the first control board is arranged close to the opening hole, and the second control board is arranged close to the air outlet passage.

Further, the fan is a centrifugal fan, the centrifugal fan is arranged on a top of the second control board to extract the airflow passing through the second control board and discharge the airflow to an outside of the box through the air outlet passage.

Further, the control box further includes an axial flow fan accommodated in the first accommodating space, the axial flow fan is located between the first control board and the second control board and is configured to blow the airflow passing through the first control board toward the second control board.

Further, the control board further includes a third control board arranged near the air outlet passage, the second control board is located between the first control board and the third control board, the axial flow fan is further configured to blow the airflow passing through the first control board to the third control board, and the centrifugal fan is also arranged on a top of the third control board.

Further, the box is provided with a blocking plate, the blocking plate is located below the opening hole and arranged opposite to the filter hole to prevent solid garbage and liquid garbage entering from the filter hole from entering the box.

Further, there is a plurality of the filter holes, and the plurality of the filter holes is arranged in a matrix and separated from each other by grids.

Further, a top of the fixing component is assembled and fixed with the upper cover, a bottom of the filter component is plug-in fitted with the box so as to enable the filter component to be capable of being limited between the box and the upper cover and to fixedly connect the box with the upper cover.

Further, the main body is provided with a reinforcing plate located beside the control box, an air inlet communicated with the filter hole is opened on the reinforcing plate, and the air inlet and the filter hole are arranged opposite to each other to facilitate the external airflow to enter the filter hole from the air inlet.

Further, the handle assembly includes a first handle and a third handle, the first handle is connected with the main body, the third handle is connected with and insulated from the first handle and is arranged on a side of the first handle away from the body, the first handle includes a first part and a second part arranged coaxially, a diameter of the first part is smaller than a diameter of the second part, and an outer side of the first part is wrapped with an insulating component.

Further, the insulating component includes a thin layer part and a protruding ring protruding outward from the thin layer part, the thin layer part is wrapped around the outer side of the first part, and the protruding ring is arranged close to the second part and enables the second part to be disconnected from the third handle.

Further, a thickness of the thin layer part is smaller than a difference in radius between the first part and the second part.

Further, a diameter of the protruding ring is greater than or equal to a diameter of the third handle.

Further, the third handle is a hollow structure, and the first part wrapped with the insulating component is inserted into the third handle and fixedly connected with the third handle.

Further, the handle assembly further includes a second handle, a first end of the second handle is connected with the main body, a second end of the second handle is connected with and insulated from the third handle, each of the first handle and the second handle includes a fixing end connected with the main body and a connecting end connected with the third handle, the fixing end and the connecting end of each of the first handle and the second handle are integrally formed, the connecting end is formed through bending the fixing end inward, and a distance between the two fixing ends is greater than a distance between the two connecting ends.

Further, the insulating component is arranged at one end of the third handle facing the first handle, and the third handle is connected in an insulated manner to the first handle through the insulating component.

Further, the garden tool further includes a height adjustment assembly, the height adjustment assembly includes a first height adjustment bracket, a second height adjustment bracket, a height adjustment connecting rod and a height adjustment handle, the height adjustment connecting rod is provided with a locking part, a limiting groove is arranged on the locking part. The main body is provided with an inserting hole corresponding to the limiting groove, the height adjustment assembly further includes a latch that passes through the inserting hole and the limiting groove at the same time, so as to enable the height adjustment connecting rod to be fixed relative to the main body.

Further, the inserting hole includes a first inserting hole and a second inserting hole, in a height direction of the garden tool, the first inserting hole and the second inserting hole are located in different planes, and the latch passes through the limiting groove, the first inserting hole and the second inserting hole at the same time.

Further, in a forward direction of the garden tool, the first inserting hole and the second inserting hole each is provided with at least two rows spaced apart and staggered from each other, and a distance in a horizontal between a first row and a last row of each of the first inserting hole and the second inserting hole is less than or equal to a length of the limiting groove in the horizontal direction.

Further, the first inserting hole and the second inserting hole each is provided with two rows, and in an extending direction of a locking part, an extending length of the limiting groove is greater than a maximum distance between the two rows of inserting holes and an edge of the main body, so as to enable orthographic projections of the two rows of inserting holes to be covered by an orthographic projection of the limiting groove.

Further, in the height direction of the garden tool, a second accommodating space is formed between the first inserting hole and the second inserting hole, the locking part extends into the second accommodating space and is movable in the second accommodating space, so as to enable the limiting groove to be located between the first inserting hole and the second inserting hole.

Further, the walking wheel assembly includes a first walking wheel and a second walking wheel arranged front and rear, and a height of the main body relative to the ground is positively correlated with a distance between the first walking wheel and the second walking wheel.

Further, height adjustment assemblies are arranged on two sides of the main body. The two first height adjustment brackets arranged on the two sides of the main body are connected by a first connecting rod, and the two second height adjustment brackets arranged on the two sides of the main body are connected by a second connecting rod. The first connecting rod can be displaced relative to the main body under a drive of the first height adjustment bracket, and the second connecting rod is rotatably connected with the main body.

Further, the first height adjustment bracket is provided with a first pivot point pivoted with the height adjustment connecting rod and a connecting shaft pivoted with the main body. A height of the first pivot point relative to the ground is smaller than a height of the connecting shaft relative to the ground. The second height adjustment bracket is provided with a second pivot point pivoted with the height adjustment connecting rod. A height of the second pivot point relative to the ground is larger than a height of the second connecting rod relative to the ground.

Further, the height adjustment connecting rod is arranged in an arc shape near the first pivot point, and at this position, the connecting shaft is located above the height adjustment connecting rod. When the height adjustment connecting rod moves in the forward direction, the connecting shaft abuts against the height adjustment connecting rod to limit a movement of the height adjustment connecting rod.

Further, the latch includes a column and an end part arranged at an upper end of the column, a diameter of the end part is larger than a diameter of the column so as to play a limiting role above the inserting hole, and a rolling ball is arranged at a lower end of the column so as to play a limiting role at a lower end of the inserting hole.

Further, the main body includes a cutter assembly, and the cutter assembly includes a main blade motor and a cutter connected with the main blade motor. The garden tool further includes an operation assembly, and the operation assembly is arranged on the handle assembly, and is used to control a state of the garden tool. The operation assembly includes a control panel and a pivotally connected self-propelled pulling rod. An inductive sensor is arranged in the control panel, and the inductive sensor controls a self-propelled triggering and a self-propelled speed change of the garden tool through sensing a position change or an angle change between the self-propelled pulling rod and the handle assembly.

Further, the inductive sensor includes a first component and a second component, and the first component and the second component are signal-connected. The first component is fixedly arranged on the control panel, and the second component is fixedly connected with the self-propelled pulling rod. When the second component moves with the self-propelled pulling rod, the first component controls the self-propelled triggering and the self-propelled speed change of the garden tool through sensing a displacement of the second component relative to the first component.

Further, the first component is a Hall sensor, and the second component is a magnetic component spaced apart from the Hall sensor. The magnetic component includes a first end and a second end that are relatively arranged. When the magnetic component moves with the self-propelled pulling rod, a position of the magnetic component close to the Hall sensor moves from the first end to the second end.

Further, the control panel includes a first panel and a second panel, the first panel is made of a metal material, and the second panel is at least partially made of a non-metallic material. The first panel and the second panel define a housing cavity, and the self-propelled pulling rod is connected with the second panel and is at least partially located in the housing cavity.

Further, the first panel is provided with a plurality of control buttons for controlling the garden tools, and the second panel is provided with lighting components for illumination.

Further, the control buttons include a power-on switch, a cutter rotating speed switching switch, a self-propelled switch and a lighting switch, and a protective rod is arranged between adjacent control buttons.

Further, the first panel is provided with a display panel for displaying information of the garden tool, and the control button is provided with an indication light for displaying its gear position.

Further, the self-propelled pulling rod and the self-propelled switch control a self-propelled movement of the garden too together. Wherein, the self-propelled switch controls a self-propelled speed and a self-propelled direction of the garden tool, and the self-propelled pulling rod and the inductive sensor control functions of the self-propelled triggering and the self-propelled speed change.

Further, the self-propelled switch includes a high gear, a low gear and a reverse gear. Or, the self-propelled switch includes an acceleration gear and a deceleration gear. Each time the acceleration gear or the deceleration gear is pressed, the self-propelled speed increases or decreases by one gear. When the deceleration gear is long pressed, the garden tool automatically enters the reverse gear.

Further, the above-mentioned operation assembly further includes a main blade pulling rod, and the main blade pulling rod and the self-propelled pulling rod are respectively arranged at the two sides of the control panel. When the power-on switch is in an activated state, the cutter rotating speed switching switch and the main blade pulling rod control the cutter assembly of the garden tool together.

Further, the disclosure further provides a control method of the garden tool. The garden tool includes the main body, the cutter assembly, the handle assembly, the walking wheel assembly and the operation assembly. The cutter assembly is arranged on the main body. The handle assembly is connected with the main body and extends backward from one side of the main body for the user to push. The walking wheel assembly is arranged below the main body and is used to carry the main body and drive the main body to walk on the ground. The operation assembly is arranged on the handle assembly and is used to control the state of the garden tool. The operation assembly includes the control panel, the self-propelled pulling rod and the main blade pulling rod. The control panel is provided with the plurality of control buttons, and the plurality of control buttons includes the power-on switch, the cutter rotating speed switching switch and the self-propelled switch. The inductive sensor is arranged in the control panel, and the inductive sensor includes the first component and the second component connected by signals. The first component is fixedly arranged in the control panel, and the second component is fixedly connected with the self-propelled pulling rod. The control method of the garden tool includes the operations as follows.

The power-on switch is activated, and the garden tool is in a standby state.

Within a predetermined time, the self-propelled pulling rod is pulled in a direction of the handle assembly, and the self-propelled pulling rod drives the second component to move relative to the first component. When an angle between the self-propelled pulling rod and the handle assembly is a first angle, the garden tool controls the walking wheel assembly to start through the inductive sensor and walks at a first speed.

When the self-propelled pulling rod is in contact with the handle assembly, the walking wheel assembly walks at a second speed, which is greater than the first speed.

Further, when the self-propelled pulling rod moves toward the direction of the handle assembly, a self-propelled speed of the walking wheel assembly increases linearly from the first speed to the second speed. Or, when the angle between the self-propelled pulling rod and the handle assembly is less than or equal to the first angle and greater than the second angle, the walking wheel assembly walks at the first speed, and when the angle between the self-propelled pulling rod and the handle assembly is less than or equal to the second angle, the walking wheel assembly walks at the second speed. Wherein, the second angle is less than the first angle.

Further, the control method further includes adjusting the self-propelled speed and the direction of the garden tool through the self-propelled switch. Wherein, the self-propelled switch includes the high gear, the low gear and the reverse gear. When the self-propelled switch is in the high gear, the self-propelled speed of the garden tool is from 0 m/s to 1.8 m/s. When the self-propelled switch is in the low gear, the self-propelled speed of the garden tool is from 0 m/s to 0.9 m/s. When the self-propelled switch is in the reverse gear, the self-propelled speed of the garden tool is lower than the speed of the low gear, and the self-propelled speed of the garden tool is from 0 m/s to 0.5 m/s.

Further, the control method further includes adjusting the self-propelled speed and direction of the garden tool by the self-propelled switch. Wherein, the self-propelled switch includes the acceleration gear and the deceleration gear. Each time the acceleration gear or the deceleration gear is pressed, the self-propelled speed increases or decreases by one gear.

Further, the acceleration gear and the deceleration gear both include a first gear, a second gear, a third gear and a fourth gear. Wherein, in the first gear, the self-propelled speed of the garden tool is from 0.5 m/s to 1.0 m/s. In the second gear, the self-propelled speed of the garden tool is from 0.7 m/s to 1.3 m/s. In the third gear, the self-propelled speed of the garden tool is from 0.8 m/s to 1.6 m/s. In the fourth gear, the self-propelled speed of the garden tool is from 0.9 m/s to 1.8 m/s.

Further, the control method further includes long pressing the deceleration gear to enable the garden tool to automatically enter the reverse gear.

Further, the control method of the garden tool includes operations as follows.

The power-on switch is activated, and the garden tool is in a standby state.

Within a predetermined time, the main blade pulling rod is pulled toward the direction of the handle assembly, and a main blade switch connected with the main blade pulling rod is turned on to control the cutter of the cutter assembly to work at a first gear rotating speed.

The rotating speed of the cutter is changed by the cutter rotating speed switching switch.

Further, the walking wheel assembly includes a first walking wheel, a second walking wheel, a first wheel hub motor and a second wheel hub motor. The first wheel hub motor is connected with the first walking wheel and is used to control a rotating speed of the first walking wheel, and the second wheel hub motor is connected with the second walking wheel and is used to control a rotating speed of the second walking wheel. The garden tool further includes a control assembly. The control assembly includes a first wheel hub controller and a second wheel hub controller. The first wheel hub controller and the second wheel hub controller are communicatively connected with each other, and the first wheel hub controller is configured to send control signals to the first wheel hub motor and the second wheel hub controller, so that the first wheel hub motor controls the first walking wheel to walk according to a set speed in the control signal. The second wheel hub controller is configured to receive the control signals sent by the first wheel hub controller and transmit them to the second wheel hub motor, so that the second wheel hub motor controls the second walking wheel to walk according to the set speed in the control signal.

Further, the second wheel hub controller is further configured to receive a real-time walking speed of the second walking wheel collected by the second wheel hub motor and transmit the real-time walking speed to the first wheel hub controller.

Further, the first wheel hub controller is further configured to receive a real-time walking speed of the first walking wheel collected by the first wheel hub motor, and compare the real-time walking speed of the first walking wheel with the real-time walking speed of the second walking wheel, so as to adjust the walking speeds of the first walking wheel and the second walking wheel in real time, so that the walking speed of the first walking wheel is the same as the walking speed of the second walking wheel, and the garden tool keeps walking in a straight line.

Further, when there is a speed difference between the real-time walking speed of the first walking wheel and the real-time walking speed of the second walking wheel and the speed difference is greater than a preset rotating speed difference threshold, the wheel hub controller with a higher walking speed controls the corresponding wheel hub motor to reduce the rotating speed, and the wheel hub controller with a lower walking speed controls the corresponding wheel hub motor to operate according to the set speed.

Further, the preset rotating speed difference threshold is 5 RPM.

Further, the first walking wheel is a driving wheel, and the second walking wheel is a driven wheel. The first wheel hub motor is a main wheel hub motor, and the second wheel hub motor is a sub wheel hub motor. The first wheel hub controller is a main wheel hub control MCU, and the second wheel hub controller is a sub wheel hub control MCU.

Further, the garden tool further includes a power supply assembly, and the power supply assembly is electrically connected with the control assembly and is used to supply power to the first wheel hub controller and the second wheel hub controller.

Further, the garden tool further includes a self-propelled start switch and a self-propelled speed regulating structure, and the self-propelled start switch and the self-propelled speed regulating structure are both electrically connected with the first wheel hub controller so that after the self-propelled start switch is started, the self-propelled speed regulating structure sends a speed regulating signal to the first wheel hub controller.

Further, the disclosure further provides a self-propelled control method of the garden tool, which includes operations as follows.

After the garden tool is powered on and started, the first wheel hub controller sends the control signal to the first wheel hub motor and the second wheel hub controller, and the first wheel hub motor controls the first walking wheel to walk according to the set speed in the control signal.

After receiving the control signal, the second wheel hub controller transmits the control signal to the second wheel hub motor, and the second wheel hub motor controls the second walking wheel to walk according to the set speed in the control signal.

The first wheel hub controller receives the real-time walking speed of the first walking wheel collected by the first wheel hub motor, and the second wheel hub controller receives the real-time walking speed of the second walking wheel collected by the second wheel hub motor and transmits it to the first wheel hub controller.

The first wheel hub controller compares the real-time walking speed of the first walking wheel with the real-time walking speed of the second walking wheel, and adjust the walking speeds of the first walking wheel and the second walking wheel in real time, so that the walking speed of the first walking wheel is the same as the walking speed of the second walking wheel, and the garden tool keeps walking in the straight line.

Further, when the first wheel hub motor controls the first walking wheel to move according to the set speed in the control signal, if the walking speed of the first walking wheel does not reach the set speed, a PWM duty cycle output by the first wheel hub controller is increased. If the walking speed of the first walking wheel reaches the set speed, the current duty cycle is maintained.

Further, when the second wheel hub motor controls the second walking wheel to move according to the set speed in the control signal, if the walking speed of the second walking wheel does not reach the set speed, a PWM duty cycle output by the second wheel hub controller is increased. If the walking speed of the second walking wheel reaches the set speed, the current duty cycle is maintained.

Further, when there is the speed difference between the real-time walking speed of the first walking wheel and the real-time walking speed of the second walking wheel and the speed difference is greater than the preset rotating speed difference threshold, the wheel hub controller with the higher walking speed controls the corresponding wheel hub motor to reduce the rotating speed, and the wheel hub controller with the lower walking speed controls the corresponding wheel hub motor to operate according to the set speed.

Further, the garden tool further includes the self-propelled start switch and the self-propelled speed regulating structure electrically connected with the first wheel hub controller. When the garden tool is powered on, the self-propelled start switch is closed, and the self-propelled speed regulating structure sends the speed regulating signal to the first wheel hub controller, and the first wheel hub controller calculates the corresponding set speed.

The beneficial effect of one or more embodiments of the disclosure is that the garden tool of the disclosure arranges both of the control box and the power box on the upper surface of the main body, the control box is close to one side of the handle assembly, and the power box is located next to the control box, so that an overall structure of the garden tool is more compact. In addition, the power box and the control box are arranged separately, which allows them to be replaced separately when an abnormality occurs in the power box or the control box, thereby reducing maintenance costs.

### BRIEF DESCRIPTION OF THE DRAWINGS

FIG. 1 is a perspective schematic view of a lawn mower according to at least an embodiment of the disclosure.
FIG. 2 is a schematic structural view of the lawn mower in FIG. 1 from another angle.
FIG. 3 is a bottom view of the lawn mower in FIG. 1.
FIG. 4 is an exploded view of a handle assembly in FIG. 1.
FIG. 5 is an enlarged view of a circled part in FIG. 4.
FIG. 6 is a perspective view of a third handle and an operation assembly in FIG. 4.
FIG. 7 is a perspective view of FIG. 6 from another angle.
FIG. 8 is an internal structural view of a control assembly in FIG. 6.
FIG. 9 is an enlarged view of a circled part in FIG. 8.
FIG. 10 is a partial enlarged view of a first walking wheel and a height adjustment assembly in FIG. 1.
FIG. 11 is an exploded view of the first walking wheel in FIG. 10.
FIG. 12 is a schematic view of FIG. 11 from another angle.
FIG. 13 is a cross-sectional view of the first walking wheel in FIG. 10.
FIG. 14 is a partial structural block view of the lawn mower in FIG. 1.
FIG. 15 is a flowchart of a self-propelled control method of the lawn mower in FIG. 1.
FIG. 16 is a specific schematic flowchart of FIG. 15.
FIG. 17 is a partial structural side view of the lawn mower in FIG. 1.
**FIG.** 18 is a schematic view of FIG. 17 from another angle.
FIG. 19 is a bottom schematic structural view of the lawn mower in FIG. 1.
FIG**.** 20 is a schematic structural view of the height adjustment assembly in FIG. 1.
**FIG.** 21 is a cross-sectional view of a partial structure of a main body in FIG. 1.
**FIG.** 22 is a top view of a partial structure of the lawn mower in FIG. 1.
FIG. 23 is an enlarged view of a circled part A in FIG. 22.
FIG. 24 is a top view of the main body with some structures removed based on FIG. 22.
FIG. 25 is an enlarged view of a circled part B in FIG. 24.
**FIG.** 26 is a schematic structural view of a latch in FIG. 25.
FIG. 27 is a perspective schematic view of the lawn mower with the handle assembly removed in FIG. 1.
FIG. 28 is an exploded view of a control box in FIG. 27.
FIG**.** 29 is a schematic structural view of a filter component and a box in FIG. 28.
**FIG.** 30 is a cross-sectional view of a control box in FIG. 28.
FIG. 31 is a combined structural view of a first control board, a second control board and a third control board in FIG. 28.
**FIG.** 32 is a side view of FIG. 31.
**FIG.** 33 is an exploded view of a power box in FIG. 27.
FIG. 34 is a control wiring view of the lawn mower according to at least an embodiment of the disclosure.

### DETAILED DESCRIPTION

In order to enable objectives, technical solutions and advantages of the disclosure to be clearer, the disclosure is described in detail below with reference to the accompanying drawings and specific embodiments.

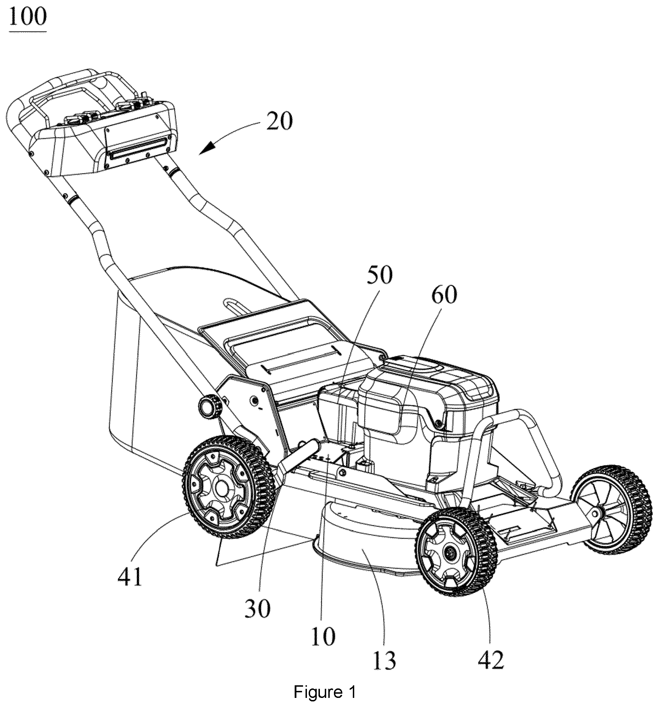

Please refer to FIG. 1 through FIG. 3. The disclosure provides a garden tool 100. The garden tool 100 includes a main body 10, a handle assembly 20, a height adjustment assembly 30, a walking wheel assembly 40, a control box 50 and a power box 60. Wherein, the handle assembly 20 is connected with the main body 10 and extends backward from one side of the main body 10 for the user to push. The height adjustment assembly 30 is arranged on one side of the main body 10, and is used to adjust a height of the main body 10 relative to a ground to meet requirements of mowing at different heights. The walking wheel assembly 40 is arranged below the main body 10, and is used to carry the main body 10 and drive the main body 10 to walk on the ground. The control box 50 and the power box 60 are both arranged on the main body 10, the power box 60 is used to supply power to the garden tool 100, and the control box 50 is used to control the garden tool 100 to work normally.

In this embodiment, the garden tool 100 is a double-blade lawn mower. The double-blade lawn mower is provided with two cutters 112. The two cutters 112 are each driven independently by a main blade motor 111, and the two cutters 112 are staggered in front and back. Of course, the garden tool 100 may also be a single-blade lawn mower, or other types of garden or non-garden machine tools. The following will take the garden tool 100 as the lawn mower as an example to describe a specific structure of the lawn mower 100 in detail.

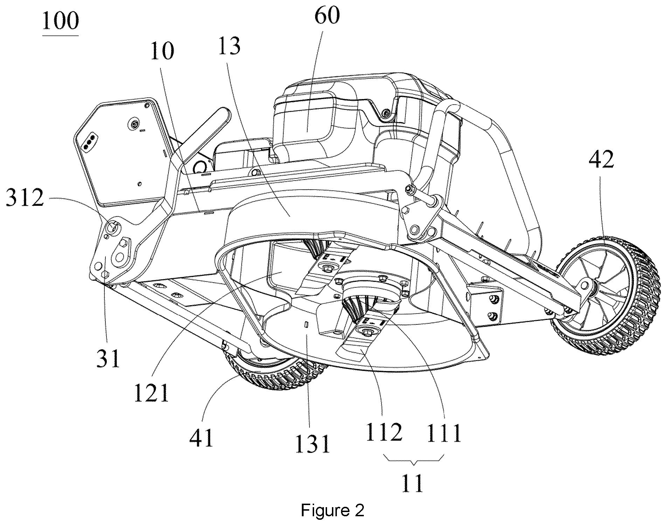

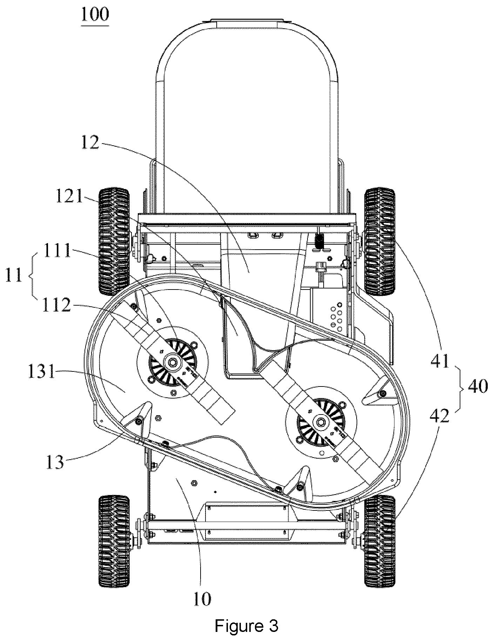

Please refer to FIG. 2 and FIG. 3. A cutting deck 13 and a cutter assembly 11 connected with the cutting deck 13 are arranged on the main body 10. The cutting deck 13 includes a cutting cavity 131 concave from a working surface toward a side away from the working surface. The cutter assembly 11 includes a main blade motor 111 and a cutter 112 connected with the main blade motor 111. Wherein, the main blade motor 111 is fixedly connected with the cutting deck 13 so that the main blade motor 111 at least partially extends into the cutting cavity 131. The cutter 112 is accommodated in the cutting cavity 131 and connected with an output shaft of the main blade motor 111, so that the main blade motor 111 drives the cutter 112 to rotate through the output shaft to cut vegetation in the cutting cavity 131.

In this disclosure, the lawn mower 100 has three gears for cutting the vegetation, namely low gear, high gear and AUTO gear. In the low gear, a rotating speed of the cutter 112 is from 3200 rpm to 3800 rpm, in some embodiments 3600 rpm. In the high gear, the rotating speed of the cutter 112 is from 3800 rpm to 4200 rpm, in some embodiments 4000 rpm. In the AUTO gear, the normal rotating speed of the cutter 112 is from 3600 rpm to 4000 rpm, in some embodiments 3600 rpm. When a current of the main blade motor 111 reaches 6 A, the rotating speed of the cutter 112 is increased to 4000 rpm.

In this disclosure, there are two cutting cavities 131 and they are communicated. The two cutting cavities 131 are respectively arranged on two sides of the main body 10 and are arranged one in front and one behind, which means that the two cutting cavities 131 are staggered relative to a forward direction of the lawn mower 100. Specifically, the cutting cavity 131 arranged on a right side of the forward direction of the lawn mower 100 is arranged forward, and the cutting cavity 131 arranged on a left side of the forward direction of the lawn mower 100 is arranged backward, which means that the two cutting cavities 131 are arranged in a shape of front right and rear left. The two cutting cavities 131 are provided with the corresponding cutter assemblies 11. The two cutter assemblies 11 are respectively arranged on two sides of the power box 60. Of course, in other embodiments, the two cutting cavities 131 may be arranged in a front left and rear right shape, or may be arranged side by side.

**The** main body 10 further includes a grass discharge passage 12 connected with the cutting deck 13. A grass discharge cavity 121 is arranged in the grass discharge passage 12. The grass discharge cavity 121 is communicated with the cutting cavity 131 for discharging the cut vegetation outward. Specifically, the cutting deck 13 is formed by stamping, and the cutting deck 13 is welded with the grass discharge passage 12, which reduces cost of the main body 10 and improves a connection stability between the cutting deck 13 and the grass discharge passage 12. Wherein, the grass discharge cavity 121 is arranged at a connection of the two cutting cavities 131, and is used to communicate the grass discharge cavity 121 with the cutting cavities 131, so that the vegetation in the cutting cavities 131 can be discharged outward through the grass discharge cavity 121.

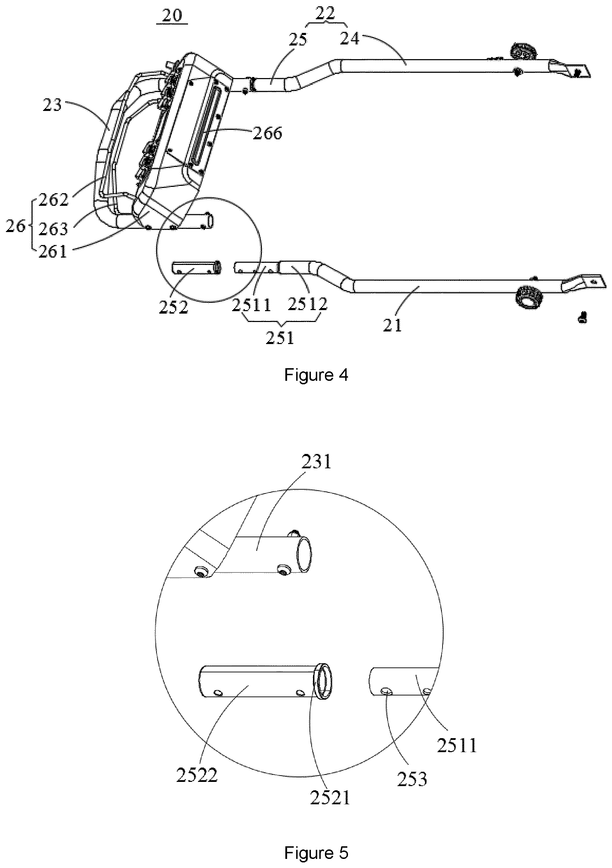

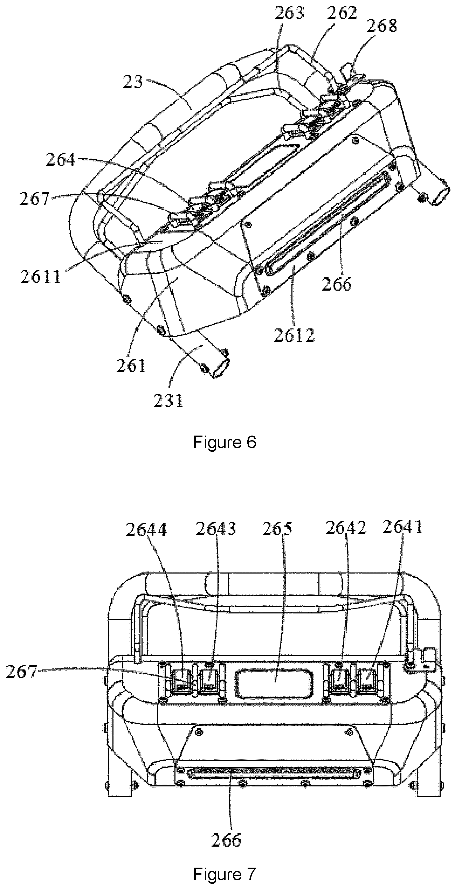

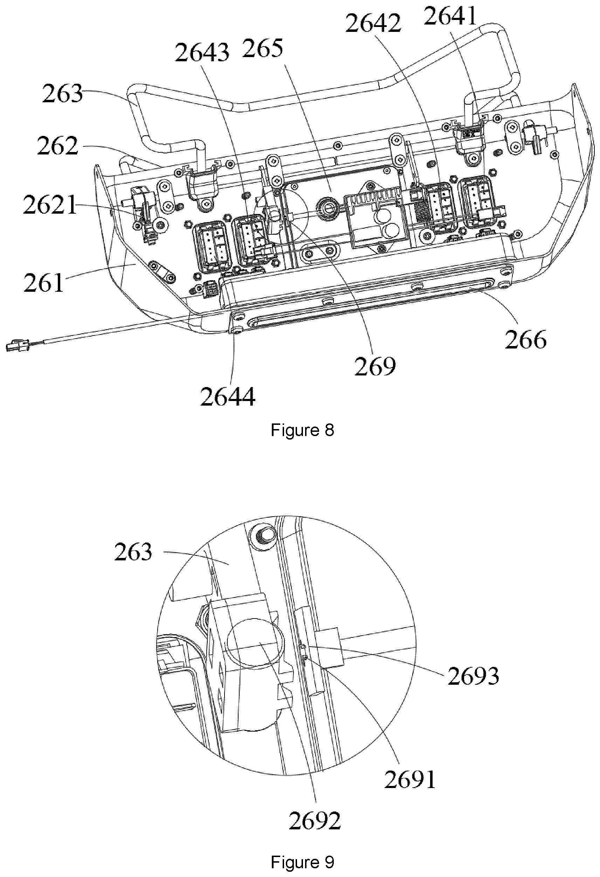

Please refer to FIG. 4 through FIG. 9. The handle assembly 20 is arranged in a U shape, and includes a first handle 21 and a second handle 22 extending backward and upward from a rear of the main body 10, and a third handle 23 connecting the first handle 21 with the second handle 22. The third handle 23 is located on a top of the handle assembly 20, so that an operator may stand behind the handle assembly 20 to hold the third handle 23 for operation.

**The** first handle 21, the second handle 22, the third handle 23 and the main body 10 are all made of metal to improve a structural strength of the lawn mower 100. The first handle 21 and the second handle 22 are both connected with the main body 10, and the first handle 21, the second handle 22 and the third handle 23 are connected in an insulated manner. Such an arrangement may prevent the current from being transmitted to the third handle 23 through the first handle 21 and the second handle 22 when an charged component on the main body 10 (such as the power box 60) leaks, thereby preventing the operator from being electrocuted and improving a safety of the lawn mower 100.

In some embodiments, the handle assembly 20 may also have only the first handle 21 and the third handle 23, or only the second handle 22 and the third handle 23. In this case, a first end of the first handle 21 or the second handle 22 is connected with the main body 10, and a second end of the first handle 21 or the second handle 22 is connected in an insulated manner to the third handle 23.

In this embodiment, the first handle 21 and the second handle 22 have a same structure and are symmetrically arranged, both including a fixing end 24 connected with the main body 10 and a connecting end 25 connected with the third handle 23, and an outer side of the connecting end 25 is wrapped with an insulating component 252 to achieve an insulated connection between the first handle 21, the second handle 22 and the third handle 23. In other embodiments, the structures of the first handle 21 and the second handle 22 may also be different, as long as the outer side of the connecting end 25 to be connected with the third handle 23 is wrapped with the insulating component 252, the insulated connection between the first handle 21, the second handle 22 and the third handle 23 can be achieved.

In order to clearly illustrate the structures of the first handle 21 and the second handle 22 and their connection relationship with the third handle 23, the first handle 21 is taken as an example for explanation. The structure and connection relationship of the second handle 22 are the same as those of the first handle 21 and are not described in detail here.

In an embodiment of the disclosure, the third handle 23 is U-shaped and has a hollow structure, and includes two U-shaped arms 231 connected with the first handle 21 and the second handle 22. The fixing end 24 of the first handle 21 is bent inwards twice continuously to form a connecting end 25, and the fixing end 24 is arranged parallel to the connecting end 25. Wherein, the outer side of the connecting end 25 is wrapped with the insulating component 252, and the connecting end 25 wrapped with the insulating component 252 is inserted into the U-shaped arm 231 of the third handle 23 to achieve an insulated connection between the first handle 21, the second handle 22 and the third handle 23. The connecting end 25 is formed by bending the fixing end 24 inward twice continuously, so that in a width direction of the main body 10, a distance between the two connecting ends 25 is less than a distance between the two fixing ends 24, so as to reduce a space occupied by the handle assembly 20 and improve an overall structural compactness of the lawn mower 100. Preferably, in this embodiment, the fixing end 24 and the connecting end 25 are integrally formed to save process effort. In other embodiments, the fixing end 24 and the connecting end 25 may also be arranged separately, assembled and connected.

In another embodiment of the disclosure, the third handle 23 is arranged in a straight line, and the fixing ends 24 of the first handle 21 and the second handle 22 are bent inward once to form the connecting end 25, which means that the fixing end 24 and the connecting end 25 are arranged at an angle, and then the connecting end 25 wrapped with the insulating component 252 is inserted into the straight-line shaped third handle 23 to achieve an insulated connection between the first handle 21, the second handle 22 and the third handle 23.

Further, the connecting end 25 includes a metal part 251, and the insulating component 252 is wrapped around an outer side of the metal part 251. Specifically, the metal part 251 includes a first part 2511 and a second part 2512 which are coaxially arranged and have different diameters. The first part 2511 is arranged close to the third handle 23, and a diameter of the first part 2511 is smaller than a diameter of the second part 2512. The insulating component 252 is sleeved on an outer side of the first part 2511. In this way, a diameter of one end of the first handle 21 close to the third handle 23 is reduced through a tube shrinking process, so that outer side of the first handle 21 can be wrapped with the insulating component 252, and the connection between the first handle 21 and the third handle 23 is the insulated connection. When the charged component on the main body 10 leaks, since the first handle 21 is a metal structure, the first handle 21 is also charged, and since the first handle 21 and the third handle 23 are in insulated connection, the charged first handle 21 cannot transmit the current to the third handle 23 through the metal part 251, thereby avoiding harm to the operator and improving the safety of the lawn mower 100.

**The** insulating component 252 may be made of insulating and wear-resistant materials such as plastic. In this embodiment, the insulating component 252 includes a thin layer part 2522 and a protruding ring 2521 protruding outward from the thin layer part 2522.

**The** thin layer part 2522 is wrapped around an outer side of the first part 2511, and a thickness of the thin layer part 2522 is smaller than a radius difference between the first part 2511 and the second part 2512. That is to say, after the insulating component 252 is sleeved on an outer side of the first part 2511, an outer diameter of the first part 2511 is still less than an outer diameter of the second part 2512. Furthermore, the third handle 23 is U-shaped and is in the hollow structure, and an outer diameter of the third handle 23 is similar to the outer diameter of the second part 2512. When the thickness of the thin layer part 2522 is smaller than the radius difference between the first part 2511 and the second part 2512, the first part 2511 sleeved with the insulating component 252 may be conveniently inserted into the third handle 23, thereby improving an overall aesthetics of the handle assembly 20. In some embodiments, an inner diameter of the insulating component 252 is greater than or equal to the outer diameter of the first part 2511 to ensure that the insulating component 252 can be sleeved on an outside of the first part 211. An inner diameter of the third handle 23 is greater than or equal to the outer diameter of the insulating component 252 to ensure that the insulating component 252 can still be inserted into the third handle 23 after being sleeved on the outside of the first part 2511.

**The** protruding ring 2521 is arranged close to the second part 2512, an outer diameter of the protruding ring 2521 is greater than or equal to the inner diameter of the third handle 23, and the protruding ring 2521 is clamped between the first handle 21 and the third handle 23. When the first part 2511 of the first handle 21 is inserted into the third handle 23, the second part 2512 of the first handle 21 cannot be directly connected with the third handle 23 due to the protruding ring 2521, thereby further improving a safety of the connection between the first handle 21 and the third handle 23. In some embodiments, the outer diameter of the protruding ring 2521 is equal to the outer diameter of the third handle 23, so that the outer diameters of the third handle 23, the protruding ring 2521 and the second part 2512 are substantially the same, so as to improve an overall aesthetics of the handle assembly 20.

**The** first handle 21 and the third handle 23 are fixedly connected by a fastener. Specifically, a first fixing hole 253 is arranged on the first part 2511 of the first handle 21 and the thin layer part 2522 of the insulating component 252, and a second fixing hole (not shown) is arranged at a corresponding position of the third handle 23. The fastener (such as a screw, etc.) passes through the first fixing hole 253 and the second fixing hole to fix the first handle 21 on the third handle 23. Of course, an insulating layer may also be arranged on the fastener to further enhance an insulation performance.

In this embodiment, through wrapping the insulating component 252 on the outer side of the connecting end 25, especially wrapping the insulating component 252 on the first part 2511 with a smaller diameter on the connecting end 25, the insulated connection of the first handle 21, the second handle 22 and the third handle 23 may be achieved. Of course, in other embodiments, the insulating component 252 may be arranged at one end of the third handle 23 facing the first handle 21 and the second handle 22, and the insulated connection of the third handle 23 with the first handle 21 and the second handle 22 may be achieved through the insulating component 252.

**At** this time, the first handle 21 and the second handle 22 are hollow structures, and the third handle 23 includes the first part 2511 and the second part 2512 which are coaxially arranged and have different diameters. Wherein, the first part 2511 is arranged close to the first handle 21/second handle 22, the insulating component 252 is arranged on an outside of the first part 2511, and the first part 2511 with the insulating component 252 is inserted into the hollow structure of the first handle 21/second handle 22, and the third handle 23 is connected in an insulated manner to the first handle 21 and the second handle 22 through the fasteners.

Furthermore, the insulating component 252 may also include the thin layer part 2522 wrapped around the first part 2511 and the protruding ring 2521 protruding outward from the thin layer part 2522 and arranged close to the first handle 21/second handle 22. Through an arrangement of the protruding ring 2521, the third handle 23 may be not directly connected with the first handle 21/second handle 22, thereby further realizing the insulated connection between the third handle 23 and the first handle 21/second handle 22, and improving the safety of the lawn mower 100.

**The** lawn mower 100 further includes the operation assembly 26 for controlling the cutter assembly 11 and the walking wheel assembly 40. The operation assembly 26 is arranged on the third handle 23 of the handle assembly 20 to facilitate the operator to use.

The operation assembly 26 includes a control panel 261, a main blade pulling rod 262 and a self-propelled pulling rod 263. The control panel 261 is arranged on the handle assembly 20, and the main blade pulling rod 262 and the self-propelled pulling rod 263 are arranged on upper and lower sides of the handle assembly 20. In some embodiments, the self-propelled pulling rod 263 is arranged below the main blade pulling rod 262. Wherein, the main blade pulling rod 262 is used to control a start of the main blade motor 111 in the cutter assembly 11, and the self-propelled pulling rod 263 is used to control a start and a rotating speed of the walking wheel assembly 40.

The control panel 261 is arranged between the two U-shaped arms 231 of the third handle 23, and a main body of the control panel 261 is located above the third handle 23, so that the operator can use the control panel 261 conveniently, a structure of the lawn mower 100 is reasonably arranged, and operator's comfort is improved.

The control panel 261 includes a first panel 2611 and a second panel 2612. A plane of the second panel 2612 is substantially perpendicular to the ground, and the first panel 2611 is substantially parallel to the ground. The first panel 2611 is made of metal material, the second panel 2612 is at least partially made of non-metal material, and the first panel 2611 is arranged close to the operator relative to the second panel 2612. Such an arrangement may improve the aesthetics of the lawn mower 100 and safety of the operator while improving a structural strength of the control panel 261.

Wherein, the first panel 2611 and the second panel 2612 are surrounded to form a housing cavity. The main blade pulling rod 262 is connected with the first panel 2611. The self-propelled pulling rod 263 is connected with the second panel 2612 and is at least partially located in the housing cavity.

The first panel 2611 is provided with a plurality of control buttons 264 for controlling the lawn mower 100 and a display panel 265 for displaying information of the lawn mower 100, and the second panel 2612 is provided with a lighting component 266 for illumination.

In this embodiment, the display panel 265 is arranged in a middle of the first panel 2611, and the plurality of control buttons 264 is distributed on two sides of the display panel 265. In other embodiments, the display panel 265 may also be arranged above or below the plurality of control buttons 264, or at other positions, which is not limited in this embodiment. In some embodiments, the control button 264 is provided with an indication light showing its gear.

**A** control circuit board is arranged in the control panel 261, and the lawn mower 100 is controlled through wired communication such as a control line or wireless communication such as Bluetooth, WIFI, infrared, etc. In this embodiment, the plurality of control buttons 264 includes a power-on switch 2641 for powering on the lawn mower 100, a cutter rotating speed switching switch 2642 for switching the rotating speed of the cutter 112, a self-propelled switch 2643 for controlling a self-propelled speed of the walking wheel assembly 40, and a lighting switch 2644 for controlling the lighting component 266. The plurality of control buttons 264 is separated by protective rods 267 to prevent the operator from accidentally touching other buttons during operation, thereby improving operational safety.

Two ends of the main blade pulling rod 262 are connected with the first panel 2611 of the control panel 261, and a shape of the main blade pulling rod 262 is the same as the third handle 23, so that the operator may control the main blade pulling rod 262 while holding the third handle 23. In some embodiments, when the power-on switch 2641 is activated, the main blade pulling rod 262 is pulled toward the third handle 23 to start the main blade motor 111 of the lawn mower 100. Specifically, first, the power-on switch 2641 is pressed, and the lawn mower 100 is in a standby state. Then, within a preset time, the main blade pulling rod 262 is pulled in a direction of the handle assembly 20, and the main blade switch 2621 linked with the main blade pulling rod 262 is turned on, so that the main blade motor 111 of the lawn mower 100 starts to run, so as to control the cutting blade 112 to work at a certain rotating speed. After the preset time has passed, the power-on switch 2641 needs to be restarted and the main blade pulling rod 262 needs to be pulled to control the main blade motor 111 of the lawn mower 100 to operate. In some embodiments, the operator may set the preset time by himself, for example, it may be one minute. In this way, misoperation may be avoided and safety may be improved. In some embodiments, an elastic device is arranged on the main blade pulling rod 262. When the main blade pulling rod 262 is released, the main blade pulling rod 262 automatically returns to an initial position by an action of the elastic device. Furthermore, a self-locking protection structure 268 is arranged at a connection between the main blade pulling rod 262 and the first panel 2611 to prevent accidental triggering and improve the operational safety.

When the rotating speed of the cutter 112 needs to be changed, it is controlled through the cutter rotating speed switching switch 2642 on the control panel 261. In some embodiments, the cutter rotating speed switching switch 2642 is divided into three levels, a lowest level being a first level rotating speed, which means a default rotating speed of the cutter 112 of the lawn mower 100 after the main blade pulling rod 262 is pulled. A middle level is a second level rotating speed, a top level is the third level rotating speed, and the third level rotating speed is greater than the second level rotating speed which is greater than the first level rotating speed.

**The** self-propelled pulling rod 263 is arranged below the handle assembly 20 and is pivotally connected with the control panel 261. An inductive sensor 269 is arranged in the housing cavity of the control panel 261. Under a premise that the power-on switch 2641 is activated, the inductive sensor 269 controls a self-propelled triggering and a self-propelled speed change of the lawn mower 100 through sensing a position or an angle change between the self-propelled pulling rod 263 and the handle assembly 20. This means that a self-propelled triggering function and a self-propelled speed change function of the lawn mower 100 may be controlled by one inductive sensor 269, which has a simple structure, reduces costs, and has diversified functions.

**The** inductive sensor 269 may be a displacement sensor, an angle sensor, or a sensor combining displacement and angle.

In this embodiment, the inductive sensor 269 is a displacement sensor, which includes a first component 2691 and a second component 2692, and the first component 2691 and the second component 2692 are signal-connected. The first component 2691 is fixedly arranged in the control panel, and the second component 2692 is fixedly connected on the self-propelled pulling rod 263. When the second component 2692 moves with the self-propelled pulling rod 263, the first component 2691 controls the self-propelled triggering and the self-propelled speed change of the lawn mower 100 through sensing a displacement of the second component 2692 relative to the first component 2691.

Further, the first component 2691 is a Hall sensor, and the second component 2692 is a magnetic component spaced apart from the Hall sensor 2691. A volume of the magnetic component 2692 is larger than a volume of the Hall sensor. The magnetic component 2692 includes a first end and a second end that are relatively arranged. When the magnetic component 2692 moves with the self-propelled pulling rod 263, a position of the magnetic component 2692 close to the Hall sensor 2691 moves from the first end to the second end. This means that when the self-propelled pulling rod 263 is in a free state (which means that when the angle between the self-propelled pulling rod 263 and the handle assembly 20 is the largest), the first end of the magnetic component 2692 is arranged close to the Hall sensor 2691. When the self-propelled pulling rod 263 is pulled by an external force to move toward the handle assembly 20, the magnetic component 2692 moves toward the handle assembly 20 along with the self-propelled pulling rod 263. At this time, the first end of the magnetic component 2692 gradually moves away from the Hall sensor 2691, and the second end of the magnetic component 2692 gradually approaches the Hall sensor 2691. The Hall sensor 2691 controls the self-propelled triggering and self-propelled speed change of the lawn mower 100 through sensing a change of the magnetic component 2692 from the first end to the second end.

In some embodiments, the magnetic component 2692 is a magnet. The magnet 2692 is arranged at a connection between the self-propelled pulling rod 263 and the second panel 2612 and is located in the housing cavity of the control panel 261, and includes an N pole and an S pole that are arranged opposite to each other. The Hall sensor 2691 is arranged on a PCB board 2693 in the housing cavity of the control panel 261. The magnet 2692 is spaced apart from and signal connected to the Hall sensor 2691. The Hall sensor 2691 senses the magnet 2692 moving from the N pole to the S pole to collect voltage data of the lawn mower 100, thereby realizing the self-propelled triggering function and self-propelled speed change function of the lawn mower 100.

Specifically, when the angle between the self-propelled pulling rod 263 and the handle assembly 20 is a first angle, the magnetic component 2692 is pulled upward together with the self-propelled pulling rod 263 and approaches the third handle 23. When the self-propelled pulling rod 263 is in a free state (which means that the angle between the self-propelled pulling rod 263 and the handle assembly 20 is a maximum angle), the N pole of the magnet 2692 is arranged close to the Hall sensor 2691. At this time, the voltage data collected by the Hall sensor 2691 does not reach self-propelled triggering voltage data required by the lawn mower 100, and the lawn mower 100 does not start the self-propelled function.

The self-propelled pulling rod 263 moves toward the direction of the third handle 23. When the angle between the self-propelled pulling rod 263 and the handle assembly 20 is the first angle (the first angle is less than the maximum angle), the magnet 2692 is pulled upward together with the self-propelled pulling rod 263 and approaches the third handle 23, which means that the N pole of the magnet 2692 gradually moves away from the Hall sensor 2691, and the S pole gradually approaches the Hall sensor 2691. The Hall sensor 2691 collects certain voltage data. When the voltage data collected by the Hall sensor 2691 reaches the self-propelled triggering voltage data required by the lawn mower 100, the self-propelled function of the lawn mower 100 is turned on, and the lawn mower 100 controls the walking wheel assembly 40 to start. At this time, the lawn mower 100 moves at a first speed.

When the self-propelled pulling rod 263 is completely fitted with the third handle 23, the magnet 2692 also rises to a maximum height along with the self-propelled pulling rod 263. At this time, the S pole of the magnet 2692 is close to the Hall sensor 2691. The Hall sensor 2691 senses highest voltage data, and the lawn mower 100 moves at a second speed, which is greater than the first speed.

In one embodiment of the disclosure, when the self-propelled pulling rod 263 moves toward the handle assembly 20, the self-propelled speed of the walking wheel assembly 40 increases linearly from the first speed to the second speed.

In another embodiment of the disclosure, when the angle between the self-propelled pulling rod 263 and the handle assembly 20 is less than or equal to the first angle and greater than the second angle, the walking wheel assembly 40 walks at the first speed, and when the angle between the self-propelled pulling rod 263 and the handle assembly 20 is less than or equal to the second angle, the walking wheel assembly 40 walks at the second speed. Wherein, the second angle is less than the first angle. For example, when the angle between the self-propelled pulling rod 263 and the third handle 23 is 30°, the voltage data collected by the Hall sensor 2691 reaches the self-propelled triggering voltage data required by the lawn mower 100, the self-propelled function of the lawn mower 100 is turned on, and the lawn mower 100 moves at the first speed. When the angle between the self-propelled pulling rod 263 and the third handle 23 is less than or equal to 30° and greater than 15°, the lawn mower 100 continues to move at the first speed. When the angle between the self-propelled pulling rod 263 and the third handle 23 is less than or equal to 15°, the lawn mower 100 moves at the second speed.

Further, the self-propelled switch 2643 on the control panel 261 and the self-propelled pulling rod 263 control the self-propelled speed of the walking wheel assembly 40 together. This means that a self-propelled start function and the self-propelled speed change function of the walking wheel assembly 40 may be controlled by the self-propelled pulling rod 263, and a self-propelled speed gear and a self-propelled direction of the walking wheel assembly 40 may be controlled by the self-propelled switch 2643.

**The** self-propelled switch 2643 includes a plurality of gears, through which the self-propelled speed and the self-propelled direction of the walking wheel assembly 40 are controlled. The self-propelled pulling rod 263 and the displacement sensor 269 control the self-propelled triggering function and the self-propelled speed change function of the walking wheel assembly 40.

In one embodiment of the disclosure, the self-propelled switch 2643 is divided into three gears, namely a high gear at a top, a low gear at a middle, and a reverse gear at a bottom. When the self-propelled switch 2643 is in the low gear, the self-propelled speed of the lawn mower 100 is between 0 m/s and 0.9 m/s. When the self-propelled switch 2643 is in the high gear, the self-propelled speed of the lawn mower 100 is between 0 m/s and 1.8 m/s. When the self-propelled switch 2643 is in the reverse gear, the self-propelled speed of the lawn mower 100 is between 0 m/s and 0.5 m/s.

In another embodiment of the disclosure, the self-propelled switch 2643 includes an acceleration gear and a deceleration gear. Each time the acceleration gear or the deceleration gear is pressed, the self-propelled speed increases or decreases by one gear. When an upper part of the self-propelled switch 2643 is pressed, the acceleration gear is triggered, and the self-propelled speed increases by one gear. After being triggered, the self-propelled switch 2643 automatically resets and can be pressed a second time, and the self-propelled speed will continue to increase by one gear. Through repeating this operation, the self-propelled speed may be increased to the highest gear. The deceleration gear is located at a lower part of the self-propelled switch 2643. Its operating principle is the same as that of the acceleration gear and will not be repeated here.

In some embodiments, the acceleration gear and the deceleration gear both include four gears, namely a first gear, a second gear, a third gear and a fourth gear. When the self-propelled switch 2643 is in the first gear, the self-propelled speed of the lawn mower 100 is between 0.5 m/s and 1.0 m/s. When the self-propelled switch 2643 is in the second gear, the self-propelled speed of the lawn mower 100 is between 0.7 m/s and 1.3 m/s. When the self-propelled switch 2643 is in the third gear, the self-propelled speed of the lawn mower 100 is between 0.8 m/s and 1.6 m/s. When the self-propelled switch 2643 is in the fourth gear, the self-propelled speed of the lawn mower 100 is between 0.9 m/s and 1.8 m/s.

**The** deceleration gear has two functions. When the deceleration gear is short pressed, the self-propelled speed of the lawn mower 100 is reduced by one gear. When the deceleration gear is long pressed, the lawn mower 100 automatically enters the reverse gear. This means that when the deceleration gear is pressed, the self-propelled speed of the lawn mower 100 automatically drops by one gear, and when the deceleration gear is continuously pressed for more than a certain time (for example, 1.5 seconds), the reverse gear is automatically triggered.

**The** disclosure further provides a self-propelled speed control method of the lawn mower 100, which includes operations as follows.

S100: the power-on switch 2641 is activated, and the lawn mower 100 is in the standby state.

**S110:** within a predetermined time, the self-propelled pulling rod 263 is pulled in the direction of the handle assembly 20, and the self-propelled pulling rod 263 drives the second component 2692 to move relative to the first component 2691. When an angle between the self-propelled pulling rod 263 and the handle assembly 20 is the first angle, the lawn mower 100 controls the walking wheel assembly 40 to start through the inductive sensor 269 and walks at the first speed.

**S120:** when the self-propelled pulling rod 263 is in contact with the handle assembly 20, the walking wheel assembly 40 walks at the second speed, which is greater than the first speed.

Further, when the self-propelled pulling rod 263 moves toward the direction of the handle assembly 20, the self-propelled speed of the walking wheel assembly 40 increases linearly from the first speed to the second speed. Or, when the angle between the self-propelled pulling rod 263 and the handle assembly 20 is less than or equal to the first angle and greater than the second angle, the walking wheel assembly 40 walks at the first speed, and when the angle between the self-propelled pulling rod 263 and the handle assembly 20 is less than or equal to the second angle, the walking wheel assembly 40 walks at the second speed. Wherein, the second angle is less than the first angle.

In one embodiment of the disclosure, the self-propelled speed control method of the lawn mower 100 further includes S130: adjusting the self-propelled speed gear and the self-propelled direction of the lawn mower 100 through the self-propelled switch 2643. Wherein, the self-propelled switch 2643 includes three gears, namely the high gear at the top, the low gear at the middle, and the reverse gear at the bottom.

When the self-propelled switch 2643 is in the low gear, the self-propelled speed of the lawn mower 100 is between 0 m/s and 0.9 m/s. This means that when the self-propelled pulling rod 263 and the third handle 23 form the first angle, the self-propelled function of the lawn mower 100 is triggered, and the self-propelled speed of the lawn mower 100 changes from 0 m/s to 0.1 m/s. When the self-propelled pulling rod 263 and the third handle 23 are completely fitted together, the self-propelled speed of the lawn mower 100 reaches the maximum, which is 0.9 m/s.

When the self-propelled switch 2643 is in the high gear, the self-propelled speed of the lawn mower 100 is between 0 m/s and 1.8 m/s. This means that when the self-propelled pulling rod 263 and the third handle 23 form the first angle, the self-propelled function of the lawn mower 100 is triggered, and the self-propelled speed of the lawn mower 100 changes from 0 m/s to 0.1 m/s. When the self-propelled pulling rod 263 and the third handle 23 are completely fitted together, the self-propelled speed of the lawn mower 100 reaches the maximum, which is 1.8 m/s.

When the self-propelled switch 2643 is in the reverse gear, the self-propelled speed of the lawn mower 100 is between 0 m/s and 0.5 m/s. This means that when the self-propelled pulling rod 263 and the third handle 23 form the first angle, the self-propelled function of the lawn mower 100 is triggered, and the self-propelled speed of the lawn mower 100 changes from 0 m/s to 0.5 m/s. When the self-propelled pulling rod 263 and the third handle 23 are completely fitted together, the self-propelled speed of the lawn mower 100 is still 0.5 m/s. Therefore, a reverse speed of the lawn mower 100 is constant, and the reverse speed is lower than the self-propelled speed of the low gear, thereby improving walking safety of the lawn mower 100.

In another embodiment of the disclosure, the self-propelled speed control method of the lawn mower 100 further includes S140: adjusting the self-propelled speed and the self-propelled direction of the lawn mower 100 through the self-propelled switch 2643. Wherein, the self-propelled switch 2643 includes the acceleration gear and the deceleration gear. Each time the acceleration gear or the deceleration gear is pressed, the self-propelled speed increases or decreases by one gear.

S140 further includes S141: when the deceleration gear is long pressed, the lawn mower 100 automatically enters the reverse gear. This means that when the deceleration gear is pressed, the self-propelled speed of the lawn mower 100 automatically drops by one gear, and when the deceleration gear is continuously pressed for more than a certain time (for example, 1.5 seconds), the reverse gear is automatically triggered.

The disclosure further provides a control method of the cutter 112, which includes operations as follows.

S200: the power-on switch 2641 is activated, and the lawn mower 100 is in the standby state.

S210: within a predetermined time, the main blade pulling rod 262 is pulled toward the direction of the handle assembly 20, and the main blade switch 2621 connected with the main blade pulling rod 262 is turned on to control the cutter 112 of the cutter assembly 11 to work at a first level rotating speed, which means that when the cutter assembly 11 is started, it works at the first level speed as the default speed.

S220: the rotating speed of the cutter 112 is changed by the cutter rotating speed switching switch 2642.

Further, S210 further includes S211 that after the preset time has passed, the power-on switch 2641 needs to be restarted and the main blade pulling rod 262 needs to be pulled to control the cutter assembly 11 of the lawn mower 100.

It should be noted that, the above-mentioned control method of the lawn mower 100 is a preferred embodiment of the disclosure, but is not limited thereto. In other embodiments, operations in the control method of the lawn mower 100 may be exchanged in order, deleted, merged or combined as needed.

The lighting switch 2644 is used to control an on/off of the lighting component 266 located on the second panel 2612. The lighting component 266 is tilted to illuminate a front of the lawn mower 100 to provide lighting conditions for the lawn mower 100. In some embodiments, a lighting range of the lighting component 266 is related to a height of the handle assembly 20. When the handle assembly 20 is raised by the height adjustment assembly 30, the lighting range of the lighting component 266 is the shortest. When the handle assembly 20 is lowered by the height adjustment assembly 30, the lighting range of the lighting component 266 is the farthest.

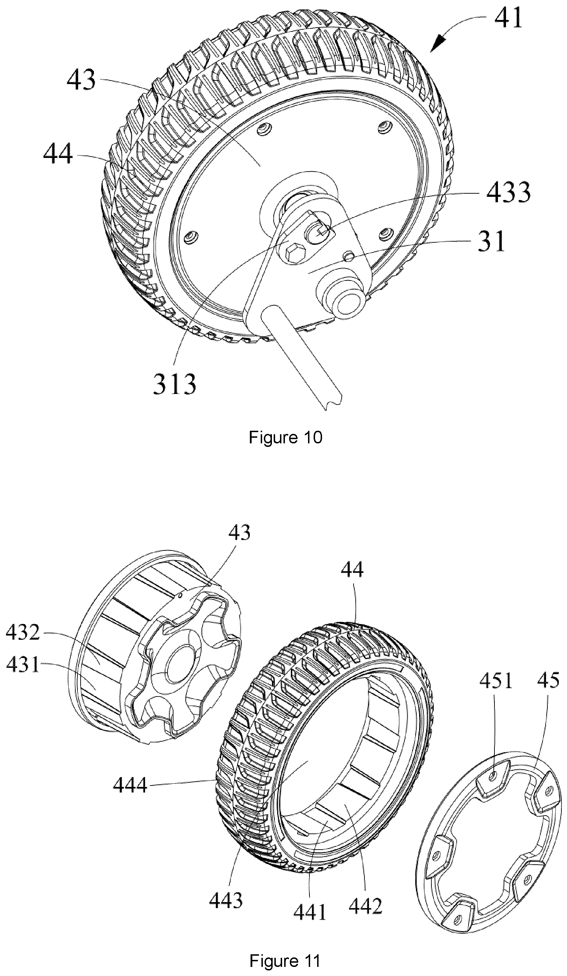

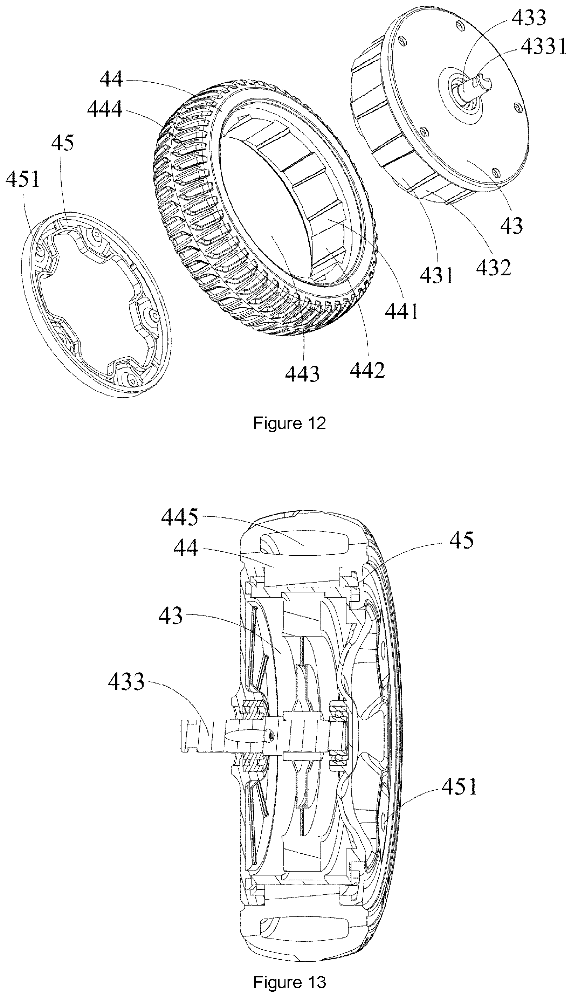

Please refer to FIG. 10 through FIG. 13 combined with FIG. 2. The walking wheel assembly 40 is arranged below the main body 10, and specifically includes a pair of first walking wheels 41 and a pair of second walking wheels 42. The first walking wheels 41 and the second walking wheels 42 are pivotally connected with the main body 10, respectively. Specifically, there are two first walking wheels 41, and both of the two first walking wheels are located on two sides of a rear of the main body 10, and connected with the main body 10 through the height adjustment assembly 30. There are two second walking wheels 42, both of the two second walking wheels are located on two sides of a front of the main body 10, and connected with the main body 10 through the height adjustment assembly 30.

The first walking wheel 41 is a driving wheel, including a wheel hub motor 43, a tire 44 and a locking part 45. The wheel hub motor 43 and the tire 44 are detachably connected. Specifically, the tire 44 is sleeved on an outer side of the wheel hub motor 43, and the locking part 45 is connected with the wheel hub motor 43 to restrict the tire 44 between the wheel hub motor 43 and the locking part 45, so as to achieve a locking and fixation between the tire 44 and the wheel hub motor 43. Wherein, the tire 44 is provided with an accommodating hole 443 for accommodating the wheel hub motor 43, and a size of the locking part 45 is larger than a size of the accommodating hole 443.

A plurality of first protruding parts 432 arranged at intervals is arranged on an outer side wall of the wheel hub motor 43. The first protruding parts 432 protrude from the outer side wall of the wheel hub motor 43 toward a side away from the wheel hub motor 43 to form a first groove 431 between two adjacent first protruding parts 432. The tire 44 includes a plurality of second protruding parts 442 formed on a side wall of the accommodating hole 443, the second protruding parts 442 extend from the tire 44 toward the accommodating hole 443, and the plurality of second protruding parts 442 is arranged at intervals on the side wall of the accommodating hole 443 to form a second groove 441 between two adjacent second protruding parts 442. Wherein, a shape and size of the second protruding part 442 are adapted to the first groove 431, and the shape and size of the second groove 441 are adapted to the first protruding parts 432, so that when the tire 44 is connected with the wheel hub motor 43, the first protruding parts 432 is accommodated in the second groove 441, and the second protruding part 442 is accommodated in the first groove 431, thereby preventing a relative rotation between the tire 44 and the wheel hub motor 43. In some embodiments, the first protruding part 432 is arranged in an inclined surface, which means that a protruding size of a first end of the first protruding part 432 close to the locking part 45 is less than a protruding size of a second end of the first protruding part 432 away from the locking part 45.

The locking part 45 includes a locking hole 451 and a locking component (not shown). During installation, the tire 44 is sleeved on the outer side of the wheel hub motor 43, and the locking part 45 is respectively abutted against the tire 44 and the wheel hub motor 43. The locking component passes through the locking hole 451 and is connected with the wheel hub motor 43 to achieve a connection between the wheel hub motor 43, the tire 44 and the locking part 45.

The tire 44 further includes an anti-skid part 444 and a filling cavity 445. Wherein, the anti-skid part 444 is arranged on an outer side wall of the tire 44 to increase a friction between the tire 44 and a working surface to prevent the tire 44 from slipping on the working surface. The filling cavity 445 is arranged inside the tire 44 and is used to be filled with gas or liquid to increase a strength of the tire 44. Of course, in other embodiments, the tire 44 may not be provided with the filling cavity 445, which means that the tire 44 is a solid tire 44.

The wheel hub motor 43 further includes a connecting shaft 433 connected with the height adjustment assembly 30. Specifically, the connecting shaft 433 is arranged at a central axis of the wheel hub motor 43 and is fixedly connected with the wheel hub motor 43. An end of the connecting shaft 433 away from the wheel hub motor 43 is connected with a first height adjustment bracket 31 of the height adjustment assembly 30, so that a height of the first walking wheel 41 relative to the main body 10 may be adjusted through the height adjustment assembly 30, and the lawn mower 100 can adapt to different workplaces, thereby improving a practicality of the lawn mower 100.

Specifically, a notch 4331 is arranged at one end of the connecting shaft 433 away from the wheel hub motor 43, and the first height adjustment bracket 31 includes a connecting hole 312 and a fixing part 313. An end of the connecting shaft 433 away from the wheel hub motor 43 passes through the connecting hole 312, so that the notch 4331 is placed on a side of the first height adjustment bracket 31 away from the wheel hub motor 43, and the fixing part 313 cooperates with the notch 4331 to connect the connecting shaft 433 with the first height adjustment bracket 31.

The second walking wheel 42 is a driven wheel with a fixed direction, which means that the second walking wheel 42 cannot change a moving direction of the lawn mower 100. The second walking wheel 42 is connected with a second height adjustment bracket 32 of the height adjustment assembly 30. A specific connection method is the same as a connection method between the first walking wheel 41 and the first height adjustment bracket 31. A height of the second walking wheel 42 relative to the main body 10 may be adjusted through the height adjustment assembly 30. A specific structure of the second walking wheel 42 may be designed according to the conventional technology and will not be elaborated here.

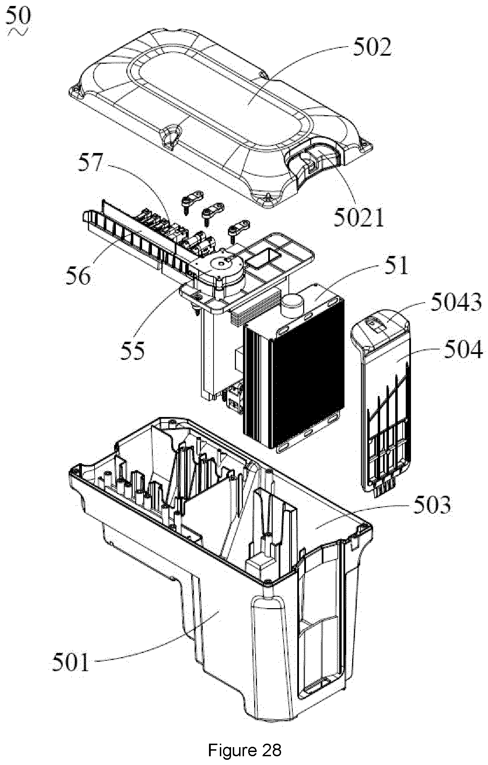

Please refer to FIG. 28. A first control board 51 for controlling a walking speed of the first walking wheels 41 is arranged in the control box 50. The first control board 51 is used to detect a rotational angular velocity of the two first walking wheels 41 respectively, and control rotating speeds of the two first walking wheels 41 according to the angular velocity, thereby controlling the moving direction of the lawn mower 100. Of course, in other embodiments, the second walking wheel 42 may also be a turning wheel. In this case, the moving direction of the lawn mower 100 may be controlled by controlling a rotating direction of the second walking wheel 42.

In this embodiment, the lawn mower 100 has three speed gears, which means that the first walking wheel 41 has three working modes, namely, the low gear, the high gear and the reverse gear. In the low gear, a rotating speed of the first walking wheel 41 is from 0 m/s to 0.9 m/s. In the high gear, the rotating speed of the first walking wheel 41 is from 0 m/s to 1.8 m/s. In the reverse gear, the rotating speed of the first walking wheel 41 is 0.5 m/s, and at this time a rotating direction of the first walking wheel 41 is opposite to the rotating direction of the first walking wheel 41 in the low gear and the high gear.

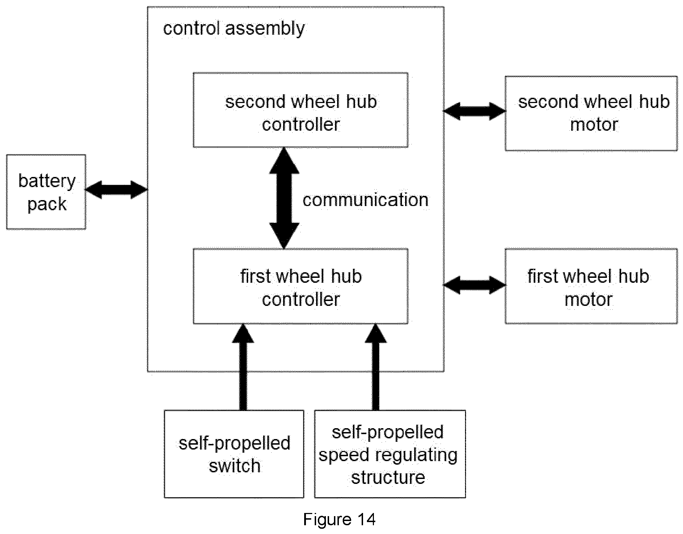

Please refer to FIG. 14. In an embodiment of the disclosure, since there are two first walking wheels 41, there are also two wheel hub motors 43 for controlling the rotating speeds of the two first walking wheels 41 respectively so that the walking speeds of the two first walking wheels 41 remain consistent, thereby ensuring that the lawn mower 100 can always move in a straight line. In some embodiments, one of the first walking wheels 41 is defined as a first rear wheel, the other first walking wheel 41 is defined as a second rear wheel, the first rear wheel is defined as a driving wheel, and the second rear wheel is defined as the driven wheel. Then the wheel hub motor connected with the first rear wheel is a first wheel hub motor, the wheel hub motor connected with the second rear wheel is a second wheel hub motor, the first wheel hub motor is a main wheel hub motor, and the second wheel hub motor is the sub wheel hub motor.

The control box 50 is provided with a control assembly for controlling the walking speed of the first rear wheel and the second rear wheel. The control assembly includes a first wheel hub controller and a second wheel hub controller. The first wheel hub controller and the second wheel hub controller are communicatively connected with each other, and the first wheel hub controller is configured to send control signals to the first wheel hub motor and the second wheel hub controller, so that the first wheel hub motor controls the first rear wheel to walk according to a set speed in the control signal. The second wheel hub controller is configured to receive the control signals sent by the first wheel hub controller and transmit them to the second wheel hub motor, so that the second wheel hub motor controls the second rear wheel to walk according to the set speed in the control signal, then the lawn mower 100 is controlled to move in the straight line.

In some embodiments, the first wheel hub controller is a main wheel hub control MCU, the second wheel hub controller is a sub wheel hub control MCU, and the two transmit data through communication. The second wheel hub controller is further configured to receive a real-time walking speed of the second rear wheel collected by the second wheel hub motor and transmit the real-time walking speed to the first wheel hub controller. The first wheel hub controller is further configured to receive a real-time walking speed of the first rear wheel collected by the first wheel hub motor, and compare the real-time walking speed of the first rear wheel with the real-time walking speed of the second rear wheel, so as to adjust the walking speeds of the first rear wheel and the second rear wheel in real time, so that the walking speed of the first rear wheel is the same as the walking speed of the second rear wheel, and the lawn mower keeps walking in the straight line.

Of course, when there is the speed difference between the real-time walking speed of the first rear wheel and the real-time walking speed of the second rear wheel and the speed difference is greater than a preset rotating speed difference threshold, the wheel hub controller with the higher walking speed controls the corresponding wheel hub motor to reduce the rotating speed, and the wheel hub controller with the lower walking speed controls the corresponding wheel hub motor to operate according to the set speed, so as to ensure that the walking speeds of the first rear wheel and the second rear wheel are uniform and can reach the set value quickly and accurately, which avoids the lawn mower 100 from being unable to walk in the straight line due to a large speed difference during operation. Further, the preset rotating speed difference threshold is 5 RPM.

The power box 60 is provided with a battery pack 61, and the battery pack 61 is electrically connected with the control assembly and is used to supply power to the first wheel hub controller and the second wheel hub controller.

The lawn mower 100 further includes a self-propelled start switch and a self-propelled speed regulating structure, and the self-propelled start switch and the self-propelled speed regulating structure are both electrically connected with the first wheel hub controller so that after the self-propelled start switch is started, the self-propelled speed regulating structure sends a speed regulating signal to the first wheel hub controller to enable the first wheel hub controller to work.

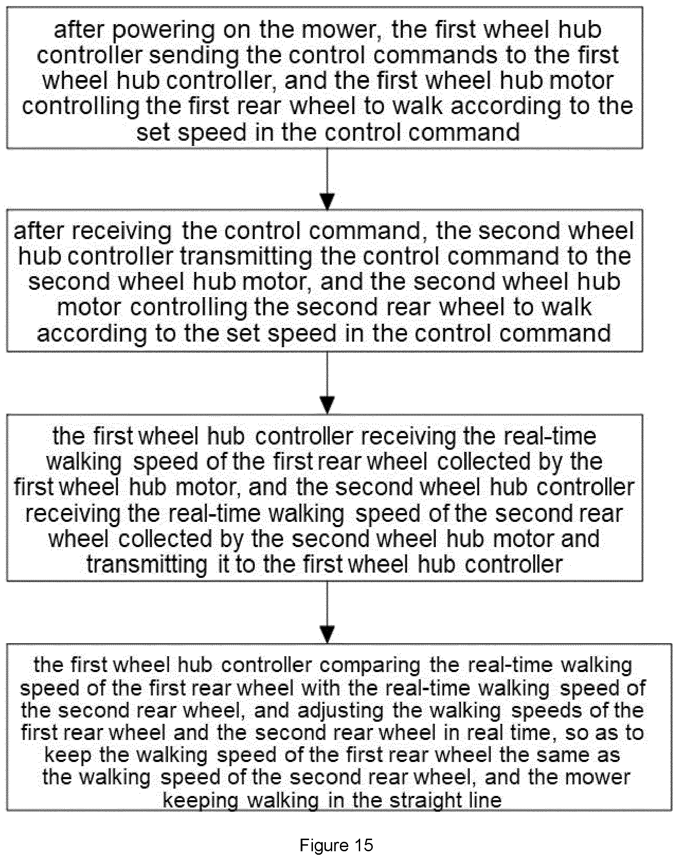

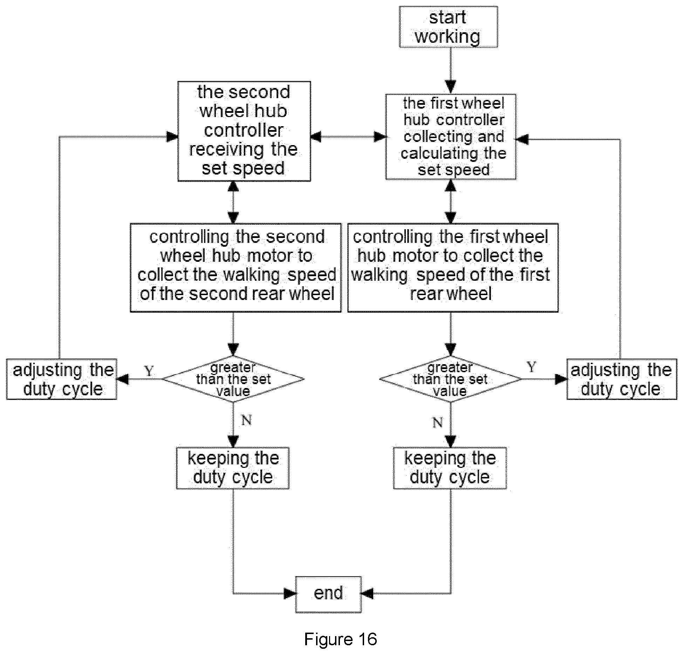

Please refer to FIG. 15 and FIG. 16. The disclosure further provides a self-propelled control method of the lawn mower, and includes operations as follows.

After the lawn mower 100 is powered on, the self-propelled start switch is closed, and the self-propelled speed regulating structure sends the speed regulating signal to the first wheel hub controller, and the first wheel hub controller calculates the corresponding set speed.

The first wheel hub controller sends the control signal to the first wheel hub motor and the second wheel hub controller, and the first wheel hub motor controls the first rear wheel to walk according to the set speed in the control signal.

After receiving the control signal, the second wheel hub controller transmits the control signal to the second wheel hub motor, and the second wheel hub motor controls the second rear wheel to walk according to the set speed in the control signal.

The first wheel hub controller receives the real-time walking speed of the first rear wheel collected by the first wheel hub motor, and the second wheel hub controller receives the real-time walking speed of the second rear wheel collected by the second wheel hub motor and transmits it to the first wheel hub controller.

The first wheel hub controller compares the real-time walking speed of the first rear wheel with the real-time walking speed of the second rear wheel, and adjusts the walking speeds of the first rear wheel and the second rear wheel in real time, so that the walking speed of the first rear wheel is the same as the walking speed of the second rear wheel, and the lawn mower 100 keeps walking in the straight line.

Specifically, when the first wheel hub motor controls the first rear wheel to move according to the set speed in the control signal, if the walking speed of the first rear wheel does not reach the set speed, a PWM duty cycle output by the first wheel hub controller is increased. If the walking speed of the first rear wheel reaches the set speed, the current duty cycle is maintained. When the second wheel hub motor controls the second rear wheel to move according to the set speed in the control signal, if the walking speed of the second rear wheel does not reach the set speed, a PWM duty cycle output by the second wheel hub controller is increased. If the walking speed of the second rear wheel reaches the set speed, the current duty cycle is maintained. If there is the speed difference between the real-time walking speed of the first rear wheel and the real-time walking speed of the second rear wheel and the speed difference is greater than the preset rotating speed difference threshold, the wheel hub controller with the higher walking speed controls the corresponding wheel hub motor to reduce the rotating speed, and the wheel hub controller with the lower walking speed controls the corresponding wheel hub motor to operate according to the set speed, so as to enable the walking speed of the first rear wheel and the second rear wheel to be consistent.

In order to better understand the above control method, a specific example is given below.

First, after the lawn mower 100 is powered on, the self-propelled start switch is closed, and the self-propelled speed regulating structure (such as a potentiometer or a Hall sensor) sends the speed regulating signal, and the first wheel hub controller collects the signal and calculates the corresponding set speed to be 1.5 M/S.

Then, the first wheel hub controller starts the first wheel hub motor, with a target rotating speed of 1.5 M/S and a hub diameter of 10.5 inches, corresponding to a rotating speed of 1.5*60/(10.5*2.54*3.14) ≈ 107 RPM for the first wheel hub motor. If the first wheel hub motor reaches the set speed, the current duty cycle is maintained. If the set speed is not reached, the duty cycle is continuously increased until the set speed is reached. If a load increases and the rotating speed decreases during a process, the duty cycle output is immediately increased. Similarly, if the load decreases and the speed increases, the duty cycle is immediately reduced to adjust the speed to the set speed in real time.

At the same time, the first wheel hub controller further sends the set speed and operating state information of the first wheel hub motor to the second wheel hub controller through communication. After receiving the data, the second wheel hub controller immediately starts the second wheel hub motor to run, with the target rotating speed of 1.5 M/S. If the first wheel hub motor reaches the set speed, the current duty cycle is maintained. If the set speed is not reached, the duty cycle is continuously increased until the set speed is reached. If the load increases and the rotating speed decreases during the process, the duty cycle output is immediately increased. Similarly, if the load decreases and the speed increases, the duty cycle is immediately reduced to adjust the speed to the set speed in real time.

The second wheel hub controller also feeds back the real-time operating state information of the second wheel hub motor to the first wheel hub controller. The first wheel hub controller quickly calculates a rotating speed difference between the first wheel hub motor and the second wheel hub motor based on the feedback information, adjusts parameter information in real time and immediately sends the parameter information to the second wheel hub controller, and adjusts operating parameters of the first wheel hub motor at the same time.

When a road condition or load changes, the rotating speed difference between the first wheel hub motor and the second wheel hub motor will be too large, which will cause the lawn mower 100 to be unable to move in the straight line. At this time, a closed-loop control is required. When the rotating speed difference is greater than the preset speed difference threshold (in some embodiments 5RPM), the wheel hub controller with a higher rotating speed controls the corresponding hub motor to reduce the speed, and the wheel hub controller with a lower rotating speed runs at the target rotating speed. This ensures that the speeds of the first wheel hub motor and the second wheel hub motor can quickly and accurately reach the set value, thereby ensuring that the lawn mower 100 can move in the straight line.

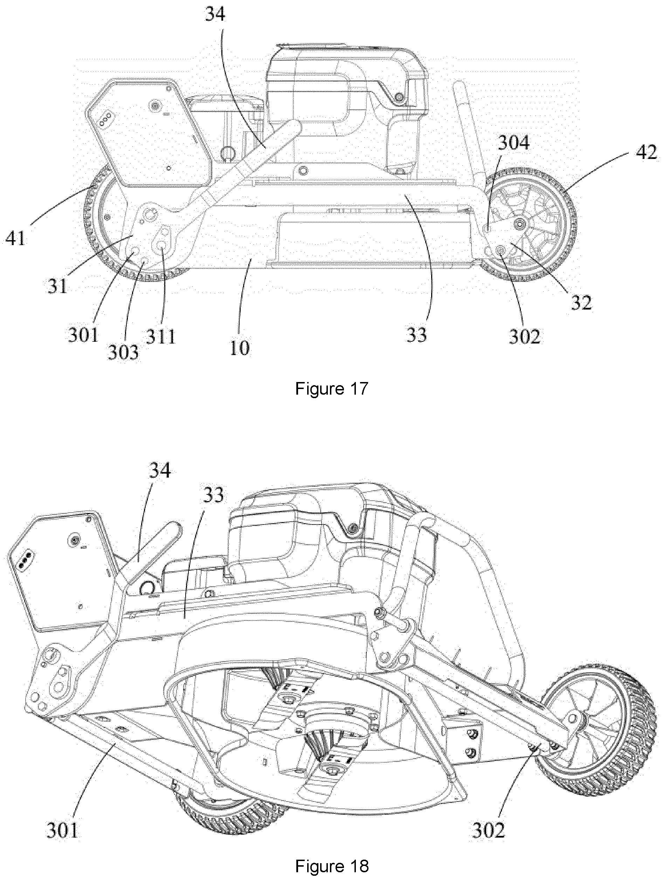

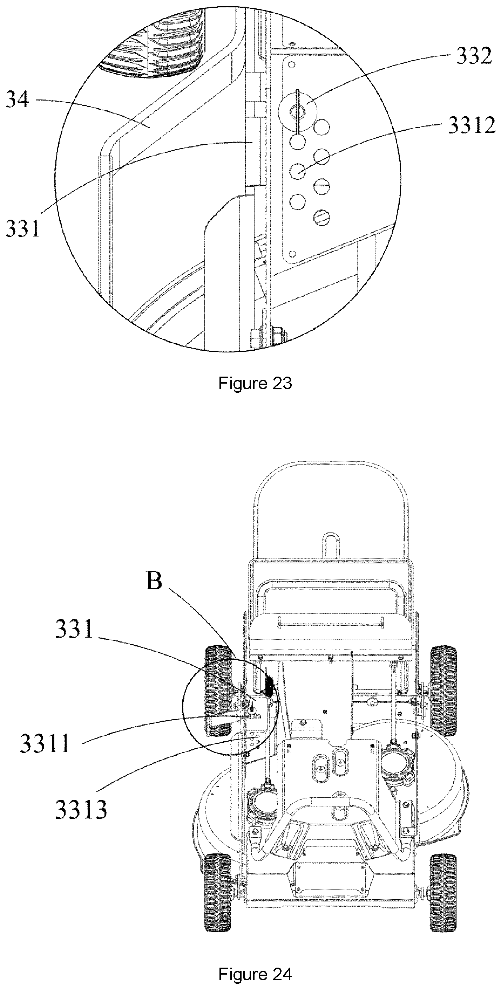

Please refer to FIG. 17 through FIG. 26 combined with FIG. 1. The height adjustment assembly 30 is used to adjust the height of the main body 10 relative to the ground. In an embodiment, the height adjustment assembly 30 includes the first height adjustment bracket 31, the second height adjustment bracket 32, a height adjustment connecting rod 33 and a height adjustment handle 34, and the height adjustment assembly 30 may also be arranged at the two sides of the main body 10.

The first height adjustment bracket 31 is arranged between the first walking wheel 41 and the main body 10. There is also a pair of the first height adjustment brackets 31 respectively located on left and right sides of the main body 10. The two first height adjustment brackets 31 are connected through a first connecting rod 301. The first walking wheels 41 are respectively pivotally connected with the corresponding first height adjustment brackets 31. The first height adjustment bracket 31 is pivotally connected with the main body 10 through a connecting shaft 311, so that when the first height adjustment bracket 31 on one side rotates, the first connecting rod 301 can drive the first height adjustment bracket 31 on the other side to rotate synchronously.

The second height adjustment bracket 32 is arranged between the second walking wheel 42 and the main body 10. There are also two second height adjustment brackets 32 respectively located on the left and right sides of the main body 10. The two second height adjustment brackets 32 are connected by a second connecting rod 302. The second walking wheels 42 are pivotally connected with the corresponding second height adjustment brackets 32 respectively, and the second height adjustment brackets 32 are pivotally connected with the main body 10 through the second connecting rod 302, so that when the second height adjustment bracket 32 on one side rotates, the second connecting rod 302 can drive the second height adjustment bracket 32 on the other side to rotate synchronously.

It should be noted that, the first height adjustment bracket 31 and the second height adjustment bracket 32 located on a same side are pivotally connected through the height adjustment connecting rod 33, which means that the first height adjustment bracket 31 and the height adjustment connecting rod 33 are pivotally connected through a first pivot point 303, and the second height adjustment bracket 32 and the height adjustment connecting rod 33 are pivotally connected through a second pivot point 304. The height adjustment connecting rod 33 can move forward and backward to drive the first height adjustment bracket 31 and the second height adjustment bracket 32 to rotate relative to the main body 10. There is a pair of height adjustment connecting rods 33. Of course, in the disclosure, in some embodiments there is only one height adjustment connecting rod 33.

Specifically, when the first height adjustment bracket 31 rotates, the first walking wheel 41 and the first connecting rod 301 simultaneously rotate around the connecting shaft 311 relative to the main body 10, which means that an axis center of the first walking wheel 41 rotates around the connecting shaft 311, thereby changing a height of the main body 10 relative to a lowest point of the first walking wheel 41 in a vertical direction, and the lowest point of the first walking wheel 41 is always lower than the lowest point of the main body 10. It should be noted that, the first connecting rod 301 and the second connecting rod 302 are not rotation center axes of the first walking wheel 41 and the second walking wheel 42, but a straight line where the first connecting rod 301 is located is parallel to a straight line where the rotation center axis of the first walking wheel 41 is located, and the straight line where the second connecting rod 302 is located is parallel to the straight line where the rotation center axis of the second walking wheel 42 is located.

When the second height adjustment bracket 32 rotates, the second connecting rod 302 rotates, and the second walking wheel 42 rotates around the second connecting rod 302, which is equivalent to an axis center of the second walking wheel 42 rotating around the second connecting rod 302, thereby changing the height of the main body 10 relative to the lowest point of the second walking wheel 42 in the vertical direction, and the lowest point of the second walking wheel 42 is always lower than the lowest point of the main body 10.

The height adjustment connecting rod 33 is arranged in an arc shape near the first height adjustment bracket 31, and at this position, the connecting shaft 311 is located above the height adjustment connecting rod 33. When the height adjustment connecting rod 33 moves forward and backward, the connecting shaft 311 abuts against the height adjustment connecting rod 33 to limit a movement of the height adjustment connecting rod 33, specifically, to limit the movement of the height adjustment connecting rod 33 beyond the connecting shaft 311 toward the other end of the first height adjustment bracket 31. A movement of the height adjustment connecting rod 33 relative to the second height adjustment bracket 32 is limited by a maximum displacement of the height adjustment connecting rod 33 in the horizontal direction.

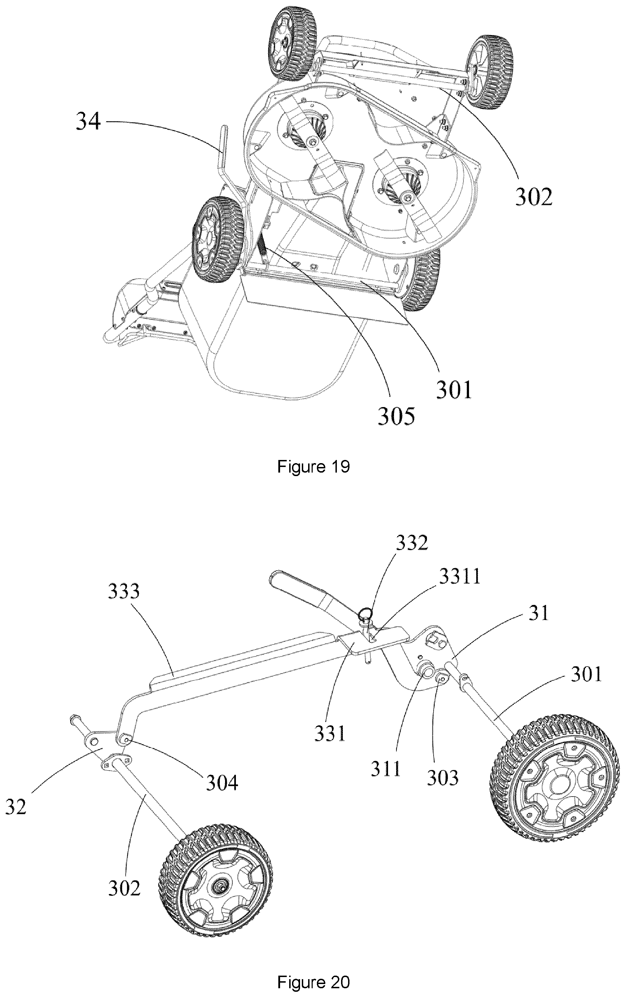

Please refer to FIG. 19. The first connecting rod 301 penetrates through the main body 10, and an elastic component 305 is arranged in the main body 10. The elastic component 305 is a spring in some embodiments. The elastic component 305 is connected with the first connecting rod 301 and the main body 10, respectively.

Further, in order to facilitate an operation of the height adjustment connecting rod 33, the height adjustment handle 34 is arranged to be located on one side of the height adjustment connecting rod 33 and is integrally arranged with the first height adjustment bracket 31. In some embodiments, the height adjustment connecting rod 33 is located between the height adjustment handle 34 and the main body 10 in a left-right direction, and the height adjustment handle 34 extends upward and is provided with a holding part at a tail end of the height adjustment handle 34 for pulling. It may be understood that, when the height adjustment handle 34 is pulled, the first height adjustment bracket 31 rotates around the connecting shaft 311, and the first connecting rod 301 and the first walking wheel 41 are driven to move upward or downward. Correspondingly, under an action of the height adjustment connecting rod 33, the second walking wheel 42 and the second connecting rod 302 are also driven to move upward or downward, so that the height of the main body 10 is adjusted. Of course, in other embodiments of the disclosure, the height adjustment handle 34 may also be connected with the height adjustment connecting rod 33, and rotate forward and backward through driving the height adjustment connecting rod 33. The first height adjustment bracket 31 and the second height adjustment bracket 32 are driven to rotate relative to the main body 10.

When a height adjustment of the main body 10 is completed, the height of the main body 10 may be fixed by only simply fixing a current position of the height adjustment connecting rod 33. In an embodiment, the height adjustment connecting rod 33 is provided with a locking part 331 extending toward the main body 10, and a limiting groove 3311 is arranged on the locking part 331. A first inserting hole 3312 and a second inserting hole 3313 for a latch 332 to pass through are arranged on the main body 10 corresponding to the limiting groove 3311, which means that the latch 332 passes through the limiting groove 3311, the first inserting hole 3312 and the second inserting hole 3313 at the same time. The first inserting hole 3312 and the second inserting hole 3313 are arranged corresponding to each other and are located in different planes in a height direction of the lawn mower 100. The locking part 331 extends into the main body 10 and enables the limiting groove 3311 to be located between the first inserting hole 3312 and the second inserting hole 3313. In the height direction of the lawn mower 100, a second accommodating space for the locking part 331 to move is formed between the first inserting hole 3312 and the second inserting hole 3313, and the locking part 331 extends into the second accommodating space and may move in the second accommodating space. The latch 332 passes through the first inserting hole 3312, the limiting groove 3311 and the second inserting hole 3313 from top to bottom respectively to limit the height adjustment connecting rod 33 in a horizontal direction, so that the first height adjustment bracket 31 and the second height adjustment bracket 32 are fixed relative to the main body 10, and the height of the main body 10 is fixed.

In particular, when the height of the main body 10 is adjusted, the height of the main body 10 from the ground will change, and a distance between the first walking wheel 41 and the second walking wheel 42 will also change. In some embodiments, when the height of the main body 10 from the ground increases, the distance between the first walking wheel 41 and the second walking wheel 42 will also increase, so that the lawn mower 100 is more stable. When the height of the main body 10 from the ground decreases, the distance between the first walking wheel 41 and the second walking wheel 42 will also decrease, so that an overall volume of the lawn mower 100 may be minimized, which is convenient for storage and transportation.

Above functions are mainly realized by different positions of the first pivot point 303 and the connecting shaft 311 (which means the rotation center), and different positions of the second pivot point 304 and the second connecting rod 302 (which means the rotation center). In an embodiment, in the vertical direction, a height of the first pivot point 303 relative to the ground is less than a height of the connecting shaft 311 relative to the ground, and a height of the second pivot point 304 relative to the ground is greater than a height of the second connecting rod 302 relative to the ground. In this way, when the height of the main body 10 from the ground increases, the distance between the first walking wheel 41 and the second walking wheel 42 increases accordingly. Conversely, when the height of the main body 10 from the ground decreases, the distance between the first walking wheel 41 and the second walking wheel 42 decreases accordingly. A height of the main body 10 relative to the ground is positively correlated with a distance between the first walking wheel 41 and the second walking wheel 42.

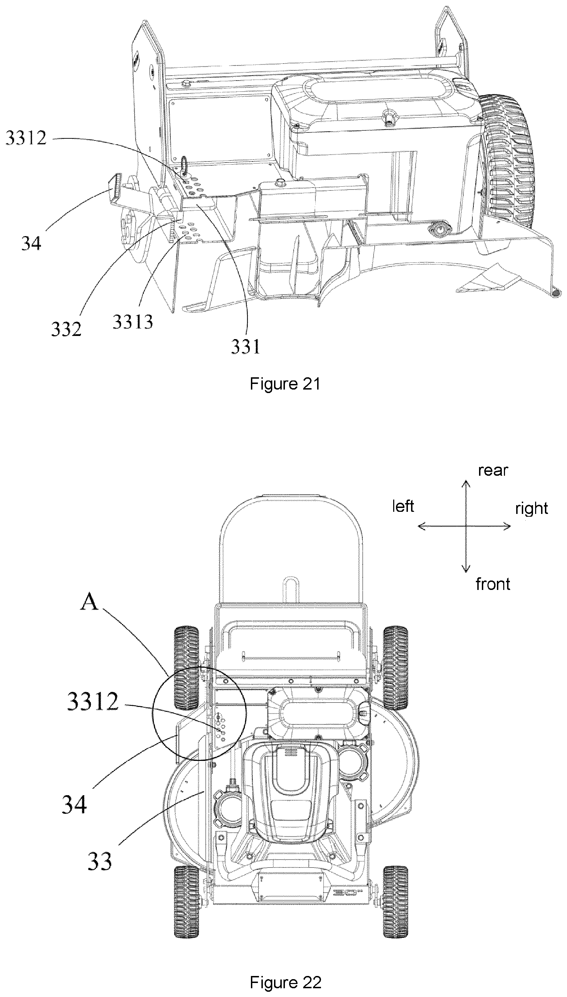

Please refer to FIG. 21 through FIG. 25. The first inserting holes 3312 and the second inserting holes 3313 each are preferably arranged in two rows and are spaced and staggered from each other in a front-rear direction and the left-right direction. In an embodiment, in the forward direction of the lawn mower 100, each row is provided with four inserting holes, and the four inserting holes are arranged in the front-rear direction. Wherein, the four inserting holes in a first row are arranged close to the height adjustment connecting rod 33, and the four inserting holes in a second row are arranged beside the four inserting holes in the first row. Each inserting hole in the second row in the left-right direction is correspondingly arranged between two adjacent inserting holes in the first row, so as to realize a staggered arrangement of the eight inserting holes. The distance between two adjacent inserting holes in a same row is equal, and in the left-right direction, each inserting hole in the second row is located in a middle position of two adjacent inserting holes in the first row, which means that the first inserting hole 3312 and the second inserting hole 3313 are provided with eight gears arranged at a same distance intervals in the forward direction of the first walking wheel 41, which is equivalent to the height of the main body 10 relative to the ground being provided with eight gears.

This means that through adjusting the limiting groove 3311 to cooperate with any inserting hole, the height of the main body 10 relative to the ground is changed. In addition, the distance between two adjacent inserting holes of the first inserting hole 3312 and the second inserting hole 3313 may be set as needed, and is not limited here, as long as the height of the main body 10 relative to the ground can be changed step by step.

For example, when the gear is adjusted upward or downward in any direction among the above eight gears, the height of the main body 10 relative to the ground changes by 0.5 cm for each gear. For example, when the above-mentioned main body 10 is at the highest height from the ground, each time the main body 10 is adjusted downward by one gear, the height of the main body 10 relative to the ground is reduced by 0.5 cm. Similarly, a maximum height to which the main body 10 can be lowered is 3.5 cm. Of course, a number of gears and a height that each gear can change to may be set as needed, and is not limited to this.

It may be understood that, since the first inserting hole 3312 are arranged in two rows, a width of the locking part 331 in the left-right direction needs to be increased, so that a length of the limiting groove 3311 in the left-right direction is greater than or equal to a horizontal distance between the first row and the second row of the first inserting holes 3312, which means that an extending length of the limiting groove 3311 in the left-right direction is greater than a farthest distance between the two rows of first inserting holes 3312 and an edge of the main body 10, and orthographic projections of the two rows of first inserting holes 3312 are covered by orthographic projections of the limiting groove 3311. In this way, when the latch 332 is located in any first inserting hole 3312, it can be matched with the limiting groove 3311, and when inserted into different first inserting holes 3312, the latch 332 is located at different parts of the limiting groove 3311.

It should be noted that, this embodiment is illustrated by two rows of first inserting holes 3312 and two rows of second inserting holes 3313, but in other embodiments, a number of rows of the first inserting holes 3312 and the second inserting holes 3313 may be set to be greater to form more adjustment gears. Correspondingly, in order to ensure that the latch 332 can be inserted into all the inserting holes, a width of the locking part 331 needs to be set to be wide enough, which means that a horizontal distance between the first row of inserting holes and the last row of inserting holes is less than or equal to a length of the limiting groove 3311 in the horizontal direction. A specific width of the locking part 331 is not limited here.

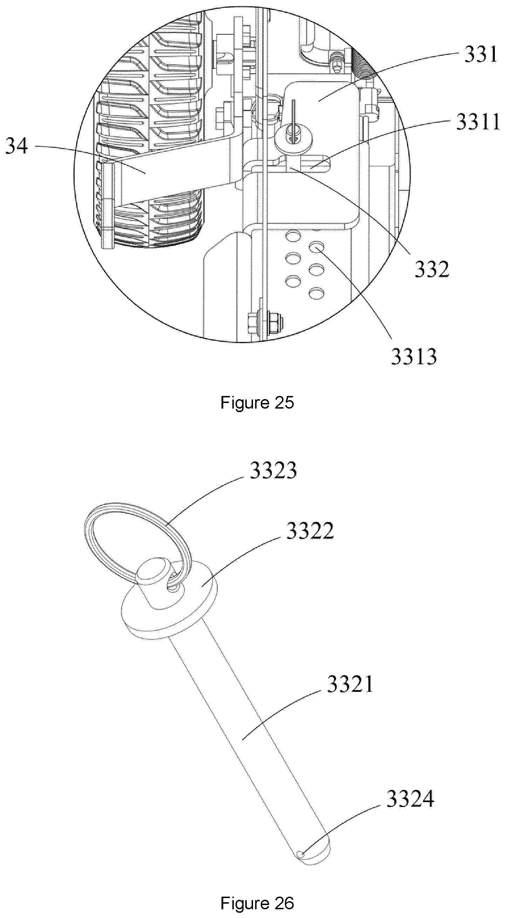

Please refer to FIG. 26. The latch 332 includes a column 3321, an end part 3322 and a pulling ring 3323. The end part 3322 and the pulling ring 3323 are arranged at an upper end of the column 3321. A rolling ball 3324 is arranged at a lower end of the column 3321. A diameter of the end part 3322 is larger than a diameter of the column 3321. The end part 3322 is used to limit a position above the first inserting hole 3312, and the rolling ball 3324 is used to limit a position at a lower end of the second inserting hole 3313, so as to enhance a fixing effect of the latch 332.

Please refer to FIG. 20. The height adjustment connecting rod 33 is further provided with a reinforcing rib 333 protruding toward one side of the height adjustment handle 34 to enhance a structural strength of the height adjustment connecting rod 33 and prevent the height adjustment connecting rod 33 from being deformed.

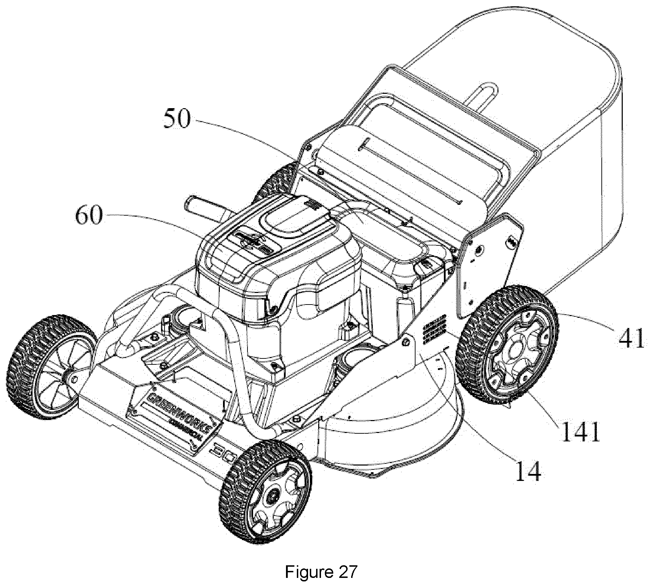

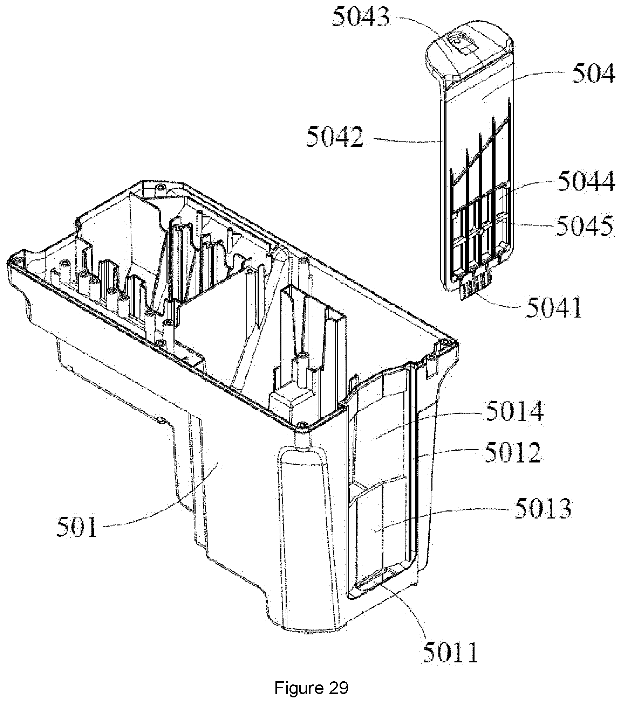

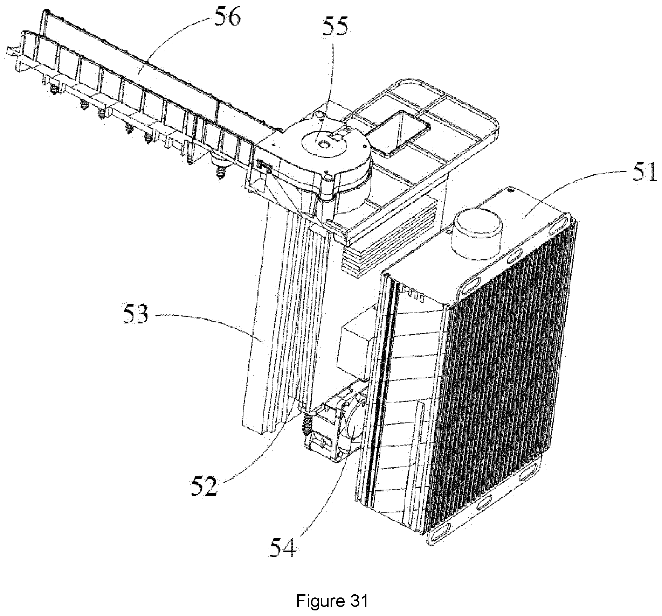

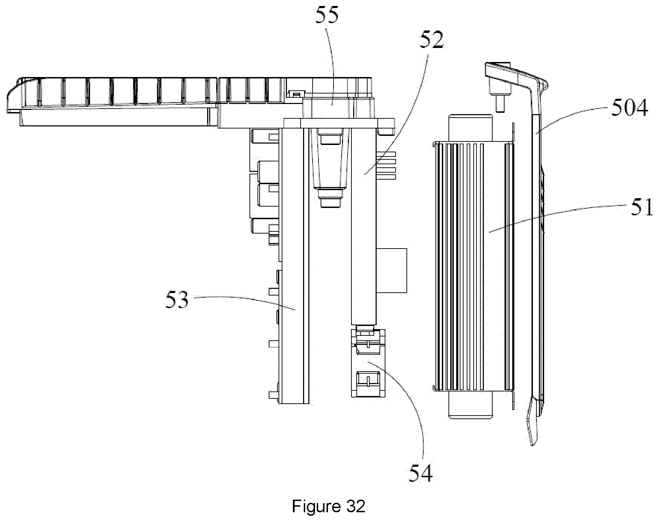

Please refer to FIG. 27 through FIG. 32. The control box 50 is arranged on a side of the main body 10 close to the handle assembly 20 and is used to control an entire operation process of the lawn mower 100. The control box 50 includes a box 501 and an upper cover 502 assembled and fixed with the box 501. The upper cover 502 covers a top of the box 501 so as to form a first accommodating space 503 between the box 501 and the upper cover 502.

The control box 50 further includes the first control board 51, the second control board 52 and a third control board 53 accommodated in the first accommodating space 503. Wherein, the first control board 51 is connected with the two wheel hub motors 43 for controlling the rotating speeds of the two wheel hub motors 43. The third control board 53 is connected with the main blade motor 111 for controlling a rotating speed of the main blade motor 111, thereby realizing a mowing function. The second control board 52 is connected with the battery pack 61 in the power box 60, and the battery pack 61 supplies power to the second control board 52. Further, the first control board 51, the second control board 52, and the third control board 53 are connected to each other so that the battery pack 61 supplies power to the first control board 51, the second control board 52, and the third control board 53, and the lawn mower 100 can operate normally.

In some embodiments, the first control board 51, the second control board 52 and the third control board 53 are arranged in sequence from left to right in the left-right direction of the lawn mower 100, so that an internal space of the entire control box 50 is more compact.

The control box 50 further includes a filter component 504 assembled with the box 501 and the upper cover 502. A top of the fixing component 504 is assembled and fixed with the upper cover 502, a bottom of the filter component 504 is plug-in fitted with the box 501 so as to enable the filter component 504 to be capable of being limited between the box 501 and the upper cover 502 and to fixedly connect the box 501 with the upper cover 502. In an embodiment, a fixing sheet 5041 protrudes from the bottom of the filter component 504, and a first fixing groove 5011 is correspondingly concave on a bottom of the box 501. Fixing strips 5042 are respectively arranged on two longitudinal sides of the filter component 504, and the fixing strips 5042 extend from the top to the bottom of the filter component 504. A second fixing groove 5012 for accommodating the fixing strips 5042 is correspondingly arranged on the box 501. A fixing part 5043 extending obliquely toward the upper cover 502 is arranged on the top of the filter component 504, and a third fixing groove 5021 is correspondingly arranged on the upper cover 502 for limiting and accommodating the fixing part 5043.

During assembly, first the box 501 is aligned with the upper cover 502, and they are assembled and fixed. Then, the fixing strips 5042 on the longitudinal sides of the filter component 504 are aligned with the second fixing grooves 5012, so that the fixing strips 5042 on two sides are respectively accommodated in the corresponding second fixing grooves 5012. Then, the filter component 504 slides toward the bottom of the box 501 until the fixing sheet 5041 extends into and is accommodated in the first fixing groove 5011. At this time, the fixing part 5043 on a top of the filter component 504 will also be accommodated in the third fixing groove 5021 of the upper cover 502. Finally, screws are used to lock and fix the fixing part 5043 and the third fixing groove 5021, and an assembly and cooperation of the filter component 504 with the box 501 and the upper cover 502 is completed.

The filter component 504 is provided with a plurality of filter holes 5044 communicated with an outside near a bottom position. The plurality of filter holes 5044 are arranged in a matrix and separated from each other by grids 5045, which means that a middle and lower part of the entire filter component 504 is in a grid shape, which is convenient for filtering external foreign matter.

The box 501 is further provided with a blocking plate 5013 arranged opposite to the filter hole 5044. The blocking plate 5013 is located above the first fixing groove 5011 and connected between the two second fixing grooves 5012, and is used to block solid waste and liquid waste entering from the filter hole 5044. In order to ensure a blocking effect, in this embodiment, the blocking plate 5013 is arranged to extend to a middle position of the box 501 in the vertical direction, which means that a height of the blocking plate 5013 is equivalent to half of a height of the box 501.

The box 501 is further provided with an opening hole 5014. In a height direction of the control box 50, the opening hole 5014 is located above the blocking plate 5013, and the opening hole 5014 is further arranged in a rectangular shape, similar to a shape of the blocking plate 5013. An arrangement of the opening hole 5014 may communicate the first accommodating space 503 of the box 501 with the outside through the opening hole 5014 and the filter hole 5044, so as to achieve heat dissipation of the control box 50.

A waterproof principle is that an arrangement of the blocking plate 5013 prevents water flowing in from the filter hole 5044 from passing over the blocking plate 5013 and entering the box 501, thereby achieving a better waterproof effect.

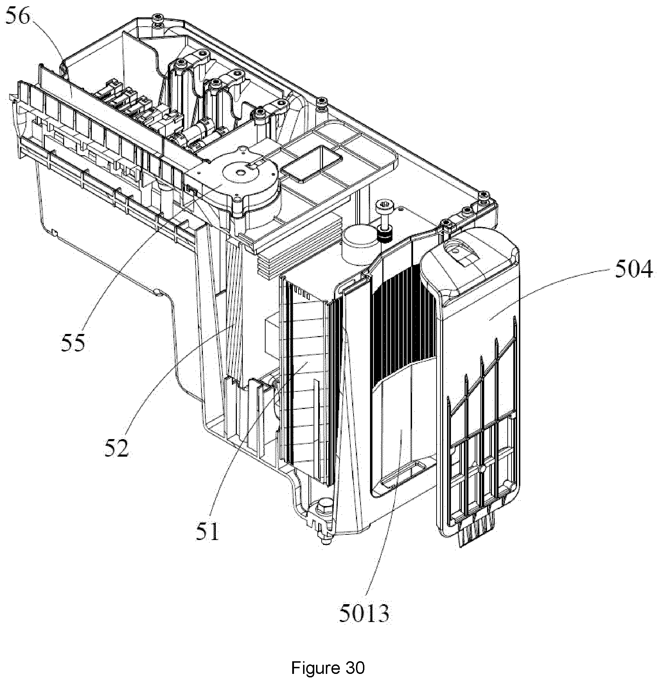

Please refer to FIG. 30 through FIG. 32. The first control board 51 is arranged near the opening hole 5014, and a first fan 54 is arranged between the first control board 51 and the second control board 52. The first fan 54 is used for blowing airflow passing through the first control board 51 toward the second control board 52 and/or the third control board 53 to dissipate heat on the second control board 52 and/or the third control board 53. In some embodiments, the first fan 54 is an axial flow fan.

A second fan 55 and an air outlet passage 56 communicated with the second fan 55 are arranged on a top of the second control board 52 and the third control board 53. The second fan 55 is used to extract airflow passing through the second control board 52 and the third control board 53 and discharge it to the outside of the box 501 through the air outlet passage 56. In some embodiments, the second fan 55 is a centrifugal fan, and the air outlet passage 56 extends in the horizontal direction. A first end of the air outlet passage 56 is communicated with an air outlet of the second fan 55, and a second end of the air outlet passage 56 extends to an end of the box 501 away from the filter component 504 and is communicated with the outside of the box 501.

In other embodiments, the first fan 54 may also be the centrifugal fan, and the second fan 55 may also be the axial flow fan. Of course, because an type of the fan changes, positions of the first fan and the second fan will also change, and these changes are well known to those skilled in the art.

Please refer to FIG. 27. The main body 10 is provided with a reinforcing plate 14 located beside the control box 50, an air inlet 141 is arranged on the reinforcing plate 14 at a position corresponding to the filter hole 5044, and the air inlet 141 is communicated with the filter hole 5044 to facilitate the external airflow to enter the filter hole 5044 from the air inlet 141. The air inlet 141 is arranged in a long groove shape and divides the filter hole 5044 in the vertical direction, so that a volume enclosed by the air inlet 141 and the filter hole 5044 is further reduced, and a preliminary filtering can be performed outside the air inlet 141 to prevent medium and large grass clippings or foreign objects from entering an interior of the box 501 through the air inlet 141 and the filter hole 5044. Of course, the reinforcing plate 14 can not only play a role in preliminary filtering, but also protect the control box 50 and support the body 10. Furthermore, the reinforcing plate 14 is a metal reinforcing plate, so that filtering, protecting and supporting functions are more obvious and effective.

A heat dissipation principle is that after the lawn mower 100 starts working, the airflow will be formed outside the reinforcing plate 14, and the airflow will drive foreign matter such as grass clippings to the air inlet 141. After the preliminary filtration at the air inlet 141, the airflow will enter the filter hole 5044 from the air inlet 141, and then first go up to the opening hole 5014, and then go down to the first accommodating space 503. A part of the airflow entering the first accommodating space 503 will pass through the first control board 51 to a side of the second control board 52, and another part of the airflow will go around a left side of the first control board 51 to a side of the second control board 52, and then be gathered and blown to the third control board 53 under an action of the first fan 54 so as to accelerate flow of heat on the third control board 53. Finally, under a suction action of the second fan 55, the airflow is gathered again at the second fan 55, flows to the air outlet passage 56, and flows to the outside of the box 501 through the air outlet passage 56. At this time, the heat dissipation of the first control board 51, the second control board 52 and the third control board 53 in the box body 501 is completed.

It should be noted that, when the air inlet 141 is used for the preliminary filtering, some grass clippings will enter the filter hole 5044 with the airflow, but these grass clippings will first collide with the blocking plate 5013 after passing through the filter hole 5044, fall to an outer bottom of the blocking plate 5013, and be located between the blocking plate 5013 and the filter component 504, which prevents the grass clippings from passing through the opening hole 5014. Since an amount of grass clippings entering the filter hole 5044 is relatively small, the filter component 504 may be disassembled after a period of time to clean the grass clippings, which is convenient and simple to operate.

The control box 50 is further provided with a plurality of wiring terminals 57, and the plurality of the wiring terminals is used to connect the first control board 51, the second control board 52 and the third control board 53 with the corresponding motors respectively to realize corresponding control functions, which will not be described in detail here.

The above is a description of the heat dissipation principle and waterproof principle of the control box 50. Next, a wiring principle of the control box 50 will be described.

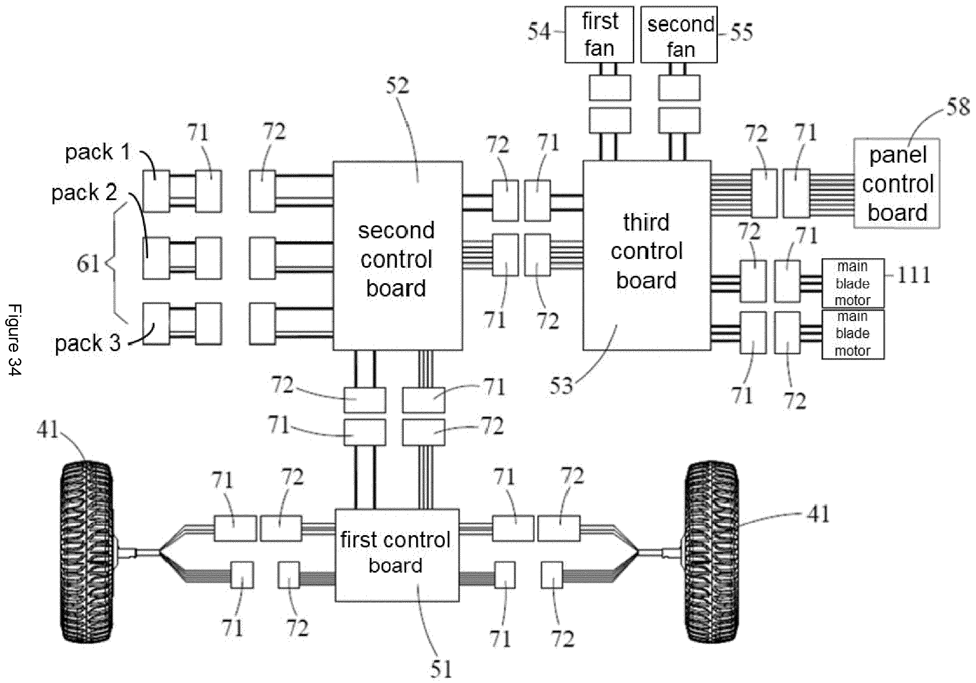

Please refer to FIG. 34. FIG. 34 is a wiring view between the first control board 51, the second control board 52 and the third control board 53. It may be seen from the figure that there are three battery packs 61, which are named pack 1, pack 2 and pack 3 respectively. The three battery packs 61 are electrically connected with the second control board 52 through a coupling of a male plug 71 and a female plug 72, power is supplied to the outside through the second control board 52, and the three battery packs 61 are connected in parallel with each other. The second control board 52 and the third control board 53 are also electrically connected with each other through a coupling of the male plug 71 and the female plug 72. Output ends of the third control board 53 are respectively connected with the first fan 54 and the second fan 55 and the two main blade motors 111, which are used to control the first fan 54, the second fan 55 and the two main blade motors 111 to work. An output end of the third control board 53 is also electrically connected with a panel control board 58 through a mutual plug-in cooperation of the male plug 71 and the female plug 72, and the panel control board 58 is used to control each component to work normally. The output end of the second control board 52 is further electrically connected with the first control board 51 through the mutual plug-in cooperation of the male plug 71 and the female plug 72 to supply power to the first control board 51. The output end of the first control board 51 is respectively connected with the two wheel hub motors 43 through the mutual plug-in cooperation of the male plug 71 and the female plug 72 to control rotating speeds of the two wheel hub motors 43.

In summary, the three battery packs 61 can be powered by an electrical connection between the first control board 51, the second control board 52, the third control board 53 and the panel control board 58, and then the first control board 51, the third control board 53 and the panel control board 58 control the corresponding components to work to ensure that the lawn mower 100 can operate normally. A specific control method is not limited.

Please refer to FIG. 27 combined with FIG. 1. The power box 60 is arranged on a side of the main body 10 away from the handle assembly 20 and close to the control box 50 for supplying power to the lawn mower 100. In this embodiment, the power box 60 and the control box 50 are independently arranged, and the power box 60 is arranged on a front side of the control box 50, so that a connecting wire between the power box 60 and the control box 50 is the shortest, a wiring is convenient, and a structure is more compact.

A biggest advantage of arranging the power box 60 and the control box 50 separately is that it is convenient for subsequent maintenance and installation. This is because: in a conventional lawn mower, the power box and the control box are integrated into a power head. When a control board in the power head fails, the entire power head needs to be disassembled and replaced. Operations are very cumbersome and replacement cost is high. After the power box 60 and the control box 50 are separately arranged in the disclosure, if a certain control board in the control box 50 is abnormal, it is only necessary to disassemble the control box 50 and replace the corresponding control board. The operations are simple and convenient, the replacement cost is relatively low, and the subsequent maintenance and installation are convenient.

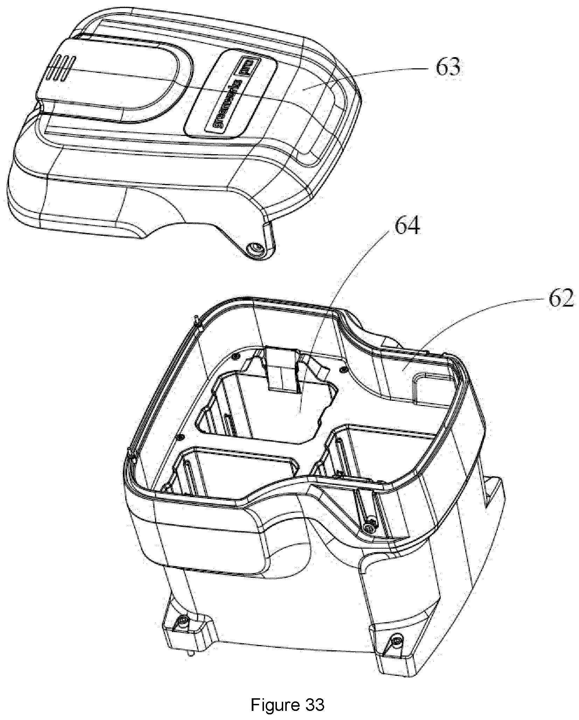

Please refer to FIG. 33. The power box 60 includes a power box body 62 and a power box cover 63 assembled and fixed to the power box body 62. The power box body 62 is provided with a battery pack accommodating cavity 64 for accommodating the battery pack 61. The battery pack 61 may be inserted into the corresponding battery pack accommodating cavity 64 and may also be taken out from the corresponding battery pack accommodating cavity 64. In this embodiment, the number of battery packs 61 is preferably three, so three battery pack accommodating cavities 64 are correspondingly arranged in the power box body 62 to accommodate the three battery packs 61. Of course, in other embodiments, the specific number of battery packs 61 and battery pack accommodating cavities 64 may be adjusted according to actual conditions and is not limited here.

Please refer to FIG. 1 through FIG. 3. The control box 50 and the power box 60 are both arranged on an upper surface of the main body 10, and the control box 50 is arranged close to a side of the handle assembly 20. The power box 60 is located on a front side of the control box 50, the main blade motor 111 is embedded in the main body 10 and protrudes into the cutting deck 13 located on a lower surface of the main body 10, and the grass discharge passage 12 is located on a bottom rear side of the main body 10 and is communicated with an inner cavity of the cutting deck 13. This arrangement enables an overall structure of the lawn mower 100 to be more compact.

In summary, the lawn mower 100 of the disclosure arranges both of the control box 50 and the power box 60 on the upper surface of the main body 10, the control box 50 is close to one side of the handle assembly 20, and the power box 60 is located next to the control box 50, so that the overall structure of the lawn mower 100 is more compact. In addition, the power box 60 and the control box 50 are arranged separately, which allows them to be replaced separately when an abnormality occurs in the power box 60 or the control box 50, thereby reducing the maintenance costs.

**The** above embodiments are only used to illustrate technical solutions of the disclosure and are not intended to limit it. Although the disclosure has been described in detail with reference to the preferred embodiments, a person skilled in the art should understand that the technical solution of the disclosure may be modified or replaced by equivalents without departing from the spirit and scope of the technical solution of the disclosure.

## Claims

1. A garden tool, comprising:
a main body;
a handle assembly, the handle assembly connected with the main body and extending backward from one side of the main body for a user to push;
a walking wheel assembly, the walking wheel assembly arranged under the main body and configured to carry the main body and drive the main body to walk on a ground;
a power box, the power box arranged on the main body and configured to supply power to the garden tool; and
a control box, the control box arranged on the main body, located beside the power box, and configured to control the garden tool to work;
wherein, the control box and the power box are both arranged on an upper surface of the main body, and the control box is arranged close to the handle assembly.

2. The garden tool according to claim 1, wherein, the control box comprises:
a box,
an upper cover, the upper cover and the box forming a first accommodating space;
a control board, the control board accommodated in the first accommodating space, a fan arranged on a top of the control board and communicated with an air outlet passage; and
a filter component, the filter component assembled and matched with the box and the upper cover, and a filter hole communicated with an outside opened at a bottom of the filter component;
wherein, the box is provided with an opening hole communicating the first accommodating space with the filter hole, in a height direction of the control box, the opening hole is located above the filter hole, the air outlet passage extends in a horizontal direction, a first end of the air outlet passage is communicated with an air outlet of the fan, a second end of the air outlet passage extends to be communicated with the outside, and the fan is configured so that external airflow enters from the filter hole, first goes up to the opening hole, then goes down to the first accommodating space, passes through the control board, gathers at the fan and flows out through the air outlet passage.

3. The garden tool according to claim 2, wherein, the control board comprises a first control board and a second control board, the first control board is arranged close to the opening hole, and the second control board is arranged close to the air outlet passage.

4. The garden tool according to claim 3, wherein, the fan is a centrifugal fan, the centrifugal fan is arranged on a top of the second control board to extract the airflow passing through the second control board and discharge the airflow to an outside of the box through the air outlet passage.

5. The garden tool according to claim 4, wherein, the control box further comprises an axial flow fan accommodated in the first accommodating space, the axial flow fan is located between the first control board and the second control board and is configured to blow the airflow passing through the first control board toward the second control board.

6. The garden tool according to claim 5, wherein, the control board further comprises a third control board arranged near the air outlet passage, the second control board is located between the first control board and the third control board, the axial flow fan is further configured to blow the airflow passing through the first control board to the third control board, and the centrifugal fan is also arranged on a top of the third control board.

7. The garden tool according to claim 2, wherein, the box is provided with a blocking plate, the blocking plate is located below the opening hole and arranged opposite to the filter hole to prevent solid garbage and liquid garbage entering from the filter hole from entering the box.

8. The garden tool according to claim 7, wherein, there is a plurality of the filter holes, and the plurality of the filter holes is arranged in a matrix and separated from each other by grids.

9. The garden tool according to claim 2, wherein, a top of the fixing component is assembled and fixed with the upper cover, a bottom of the filter component is plug-in fitted with the box so as to enable the filter component to be capable of being limited between the box and the upper cover and to fixedly connect the box with the upper cover.

10. The garden tool according to claim 2, wherein, the main body is provided with a reinforcing plate located beside the control box, an air inlet communicated with the filter hole is opened on the reinforcing plate, and the air inlet and the filter hole are arranged opposite to each other to facilitate the external airflow to enter the filter hole from the air inlet.

11. The garden tool according to claim 1, wherein, the handle assembly comprises a first handle and a third handle, the first handle is connected with the body, the third handle is connected with and insulated from the first handle and is arranged on a side of the first handle away from the body, the first handle includes a first part and a second part arranged coaxially, a diameter of the first part is smaller than a diameter of the second part, and an outer side of the first part is wrapped with an insulating component.

12. The garden tool according to claim 11, wherein, the insulating component comprises a thin layer part and a protruding ring protruding outward from the thin layer part, the thin layer part is wrapped around the outer side of the first part, and the protruding ring is arranged close to the second part and enables the second part to be disconnected from the third handle.

13. The garden tool according to claim 11, wherein, the third handle is a hollow structure, and the first part wrapped with the insulating component is inserted into the third handle and fixedly connected with the third handle.

14. The garden tool according to claim 11, wherein, the handle assembly further comprises a second handle, a first end of the second handle is connected with the main body, a second end of the second handle is connected with and insulated from the third handle, each of the first handle and the second handle comprises a fixing end connected with the main body and a connecting end connected with the third handle, the fixing end and the connecting end of each of the first handle and the second handle are integrally formed, the connecting end is formed through bending the fixing end inward, and a distance between the two fixing ends is greater than a distance between the two connecting ends.

15. The garden tool according to claim 11, wherein, the insulating component is arranged at one end of the third handle facing the first handle, and the third handle is insulated from and connected with the first handle through the insulating component.

16. The garden tool according to claim 1, wherein, the garden tool further comprises a height adjustment assembly, the height adjustment assembly comprises a first height adjustment bracket, a second height adjustment bracket, a height adjustment connecting rod and a height adjustment handle, the height adjustment connecting rod is provided with a locking part, a limiting groove is arranged on the locking part, the main body is provided with an inserting hole corresponding to the limiting groove, the height adjustment assembly further comprises a latch that passes through the inserting hole and the limiting groove at the same time, so as to enable the height adjustment connecting rod to be fixed relative to the main body.

17. The garden tool according to claim 16, wherein, the inserting hole comprises a first inserting hole and a second inserting hole, in a height direction of the garden tool the first inserting hole and the second inserting hole are located in different planes, and the latch passes through the limiting groove, the first inserting hole and the second inserting hole at the same time.

18. The garden tool according to claim 17, wherein, in a forward direction of the garden tool, the first inserting hole and the second inserting hole each is provided with at least two rows spaced apart and staggered from each other, and a distance in a horizontal between a first row and a last row of each of the first inserting hole and the second inserting hole is less than or equal to a length of the limiting groove in the horizontal direction.

19. The garden tool according to claim 18, wherein, the first inserting hole and the second inserting hole each is provided with two rows, and in an extending direction of a locking part, an extending length of the limiting groove is greater than a maximum distance between the two rows of inserting holes and an edge of the main body, so as to enable orthographic projections of the two rows of inserting holes to be covered by an orthographic projection of the limiting groove.

20. The garden tool according to claim 17, wherein, in the height direction of the garden tool, a second accommodating space is formed between the first inserting hole and the second inserting hole, the locking part extends into the second accommodating space and is movable in the second accommodating space, so as to enable the limiting groove to be located between the first inserting hole and the second inserting hole.
